# EUROPEAN PATENT APPLICATION

(11) **EP 4 546 432 A1**
(43) Date of publication of application: **30.04.2025**
(21) Application number: 24181623.0
(22) Date of filing: 12.06.2024
(51) Int. Cl.: H01L 29/775, H01L 21/336, H01L 29/06, H01L 29/417, H01L 29/423, H01L 21/8234, H01L 23/528, B82Y 10/00

(54) **SEMICONDUCTOR DEVICE AND MANUFACTURING METHOD THEREOF**

(30) Priority: 26.10.2023 KR 20230144679
(71) Applicant: Samsung Electronics Co., Ltd., Suwon-si, Gyeonggi-do 16677 (KR)
(72) Inventor: NAM, Seowoo, 16677 Suwon-si, Gyeonggi-do (KR); SHIN, Heonjong, 16677 Suwon-si, Gyeonggi-do (KR); KIM, Sunwoo, 16677 Suwon-si, Gyeonggi-do (KR); HAN, Sunggyu, 16677 Suwon-si, Gyeonggi-do (KR)
(74) Representative: Kuhnen & Wacker Patent- und Rechtsanwaltsbüro PartG mbB

(57) **Abstract**

A semiconductor device may include a base insulation layer (100), a channel layer (CH) on a first surface of the base insulation layer (100), a first source/drain pattern (151) and a second source/drain pattern (152) spaced apart from each other in a first direction (D1) on a first surface of the base insulating layer (100) with the channel layer (CH) therebetween, a gate structure (GS) on the first surface of the base insulation layer (100) and extending in a second direction (D2) crossing the first direction (D1), a lower wire structure (220) on a second surface of the base insulation layer (100), and a through electrode (190) spaced apart from the gate structure with the first source/drain pattern (151) between the through electrode (190) and the gate structure. The through electrode (190) may penetrate the base insulation layer (100) and electrically connect the first source/drain pattern (151) to the lower wire structure (220). The first direction (D1) may be parallel to the first surface of the base insulation layer (100).

## Description

### BACKGROUND

### 1. Field

The present disclosure relates to a semiconductor device and a manufacturing method thereof.

### 2. Description of the Related Art

Semiconductor devices are used in various electronic devices, such as storage devices that store data and processors that calculate and process data. With the development of the electronic industry, various methods for improving various characteristics such as integration, reliability, speeds, and functions of the semiconductor devices are being researched. For example, the semiconductor devices having a three-dimensional structure have been proposed to overcome the limitations caused by the size reduction of the semiconductor devices.

Recently, research is being conducted to improve routing congestion and scale the size of semiconductor devices by placing a power delivery network on the back of the substrate to route signals provided to semiconductor devices.

### SUMMARY

The present disclosure attempts to provide a semiconductor device in which a backside power delivery network is implemented by using a streamlined manufacturing process and a manufacturing method thereof.

According to an example embodiment, a semiconductor device may include a base insulation layer including a first surface and a second surface opposing each other; a channel layer on the first surface of the base insulation layer; a first source/drain pattern and a second source/drain pattern spaced apart from each other in a first direction on the first surface of the base insulating layer with the channel layer therebetween, the first direction being parallel to the first surface of the base insulation layer; a gate structure extending in a second direction on the first surface of the base insulation layer, the second direction crossing the first direction, and the gate structure surrounding the channel layer; a lower wire structure on the second surface of the base insulation layer; and a through electrode spaced apart from the gate structure with the first source/drain pattern between the through electrode and the gate structure, the through electrode penetrating the base insulation layer and electrically connecting the first source/drain pattern to the lower wire structure.

According to an example embodiment, a method of manufacturing a semiconductor device may include forming a channel layer, a first source/drain pattern, and a second source/drain pattern on a first surface of a substrate with the channel layer between the first source/drain pattern and the second source/drain pattern in a first direction, the first direction being parallel to the first surface of the substrate; forming a gate structure extending in a second direction on the first surface of the substrate, the gate structure surrounding the channel layer in the second direction, the second direction crossing the first direction; forming a base insulation layer, the forming the base insulation layer including removing a portion or all of the substrate and forming the base insulation layer in a region in which the portion or all of the substrate is removed; forming a through electrode spaced apart from the gate structure with the first source/drain pattern between the through electrode and the gate structure, the through electrode penetrating the base insulation layer and being connected to the first source/drain pattern; and forming a lower wire structure on a lower surface of the base insulation layer, the lower wire structure being connected to the through electrode.

According to an example embodiment, a semiconductor device may include a base insulation layer including first surface and a second surface opposing each other; a channel layer on the first surface of the base insulation layer; a first source/drain pattern and a second source/drain pattern on the first surface of the base insulation layer and in a first direction with the channel layer therebetween, the first direction being parallel to the first surface of the base insulation layer; a gate structure extending in a second direction on the first surface of the base insulation layer, the second direction crossing the first direction, and the gate structure surrounding the channel layer in the second direction; an interlayer insulation layer covering the first source/drain pattern, the second source/drain pattern, and the gate structure; an upper wire structure on the interlayer insulation layer; a lower wire structure on the second surface of the base insulation layer; a through electrode spaced apart from the gate structure with the first source/drain pattern between the through electrode and the gate structure, the through electrode penetrating the base insulation layer and electrically connecting the first source/drain pattern to the lower wire structure; and a contact electrode penetrating the interlayer insulation layer, the contact electrode having a first end connected to the second source/drain pattern and a second end connected to the upper wire structure.

According to embodiments, some of gate structures may be used as electrodes for connecting the backside power delivery network and the source/drain patterns. According to embodiments, the source/drain patterns and the backside power delivery network of the semiconductor devices may be connected by using a previously used structure and manufacturing process, and accordingly, a manufacturing process of a semiconductor device may be streamlined and cost may be reduced.

### BRIEF DESCRIPTION OF THE DRAWINGS

FIG. 1 is a top plan view showing a semiconductor device according to an embodiment.
FIG. 2 is a cross-sectional view of a semiconductor device taken along line I-I' of FIG. 1.
FIG. 3 is a cross-sectional view of a semiconductor device taken along line II-II' of FIG. 1.
FIG. 4 is a cross-sectional view of a semiconductor device taken along line III-III' of FIG. 1.
FIG. 5 to FIG. 19 are drawings for explaining a method of manufacturing a semiconductor device according to an embodiment.
FIG. 20 is a top plan view showing a semiconductor device according to an embodiment.
FIG. 21 is a cross-sectional view of a semiconductor device taken along line I-I' of FIG. 20.
FIG. 22 is a cross-sectional view of a semiconductor device taken along li7ne II-II' of FIG. 20.
FIG. 23 is a cross-sectional view of a semiconductor device taken along line III-III' of FIG. 20.
FIG. 24 to FIG. 40 are drawings for explaining a method of manufacturing a semiconductor device according to an embodiment.
FIG. 41 is a top plan view showing a semiconductor device according to an embodiment.
FIG. 42 is a cross-sectional view of a semiconductor device taken along line IV-IV' of FIG. 41.
FIG. 43 is a cross-sectional view of a semiconductor device taken along line V-V' of FIG. 41.

### DETAILED DESCRIPTION

The present disclosure will be described in detail hereinafter with reference to the accompanying drawings, in which embodiments of the present disclosure are shown. As those skilled in the art would realize, the described embodiments may be modified in various different ways, all without departing from the scope of the present disclosure.

The drawings and description are to be regarded as illustrative in nature and not restrictive. Like reference numerals designate like elements throughout the specification.

Size and thickness of each constituent element in the drawings are arbitrarily illustrated for better understanding and ease of description, the following embodiments are not limited thereto. In the drawings, the thickness of layers, films, panels, regions, etc., are exaggerated for clarity. In the drawings, the thickness of some layers and regions may be exaggerated for ease of description.

In addition, it will be understood that when an element such as a layer, film, region, or substrate is referred to as being "above" or "on" another element, it can be directly on the other element or intervening elements may also be present. In contrast, when an element is referred to as being "directly on" another element, there are no intervening elements present. Further, when an element is referred to as being "above" or "on" a reference element, it can be positioned above or below the reference element, and it is not necessarily referred to as being positioned "above" or "on" in a direction opposite to gravity.

Further, In addition, unless explicitly described to the contrary, the word "comprise", and variations such as "comprises" or "comprising", will be understood to imply the inclusion of stated elements but not the exclusion of any other elements.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

In the drawings for a semiconductor device according to an embodiment, as a mere example, gate-all-around (GAA) and MBCFET^{™} (Multi-Bridge Channel Field Effect Transistor) including nanowires or nanosheets are illustrated, but it is not limited thereto. Depending on the embodiment, the semiconductor device may include a fin-type transistor (FinFET) including a channel region of a fin pattern shape, a tunneling transistor (tunneling FET), a 3D stack field effect transistor (3DSFET) structure, complementary field effect transistor (CFET) structure.

Hereinafter, a semiconductor device according to embodiments will be described with reference to drawings.

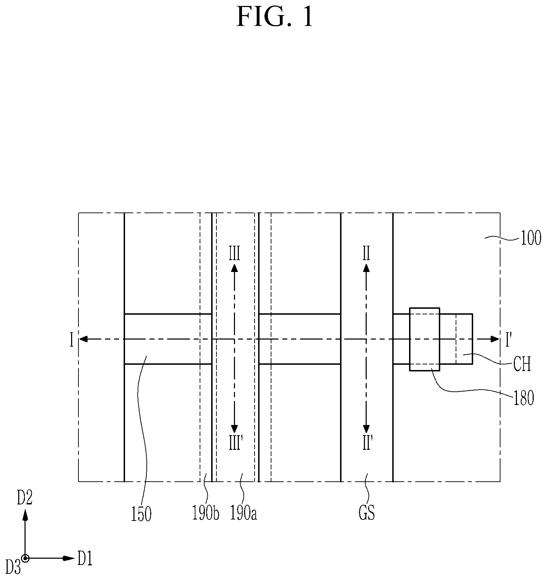

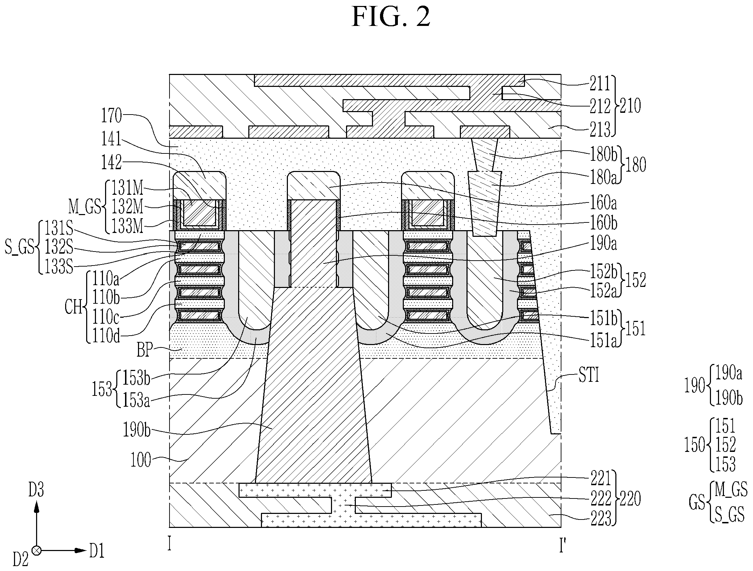

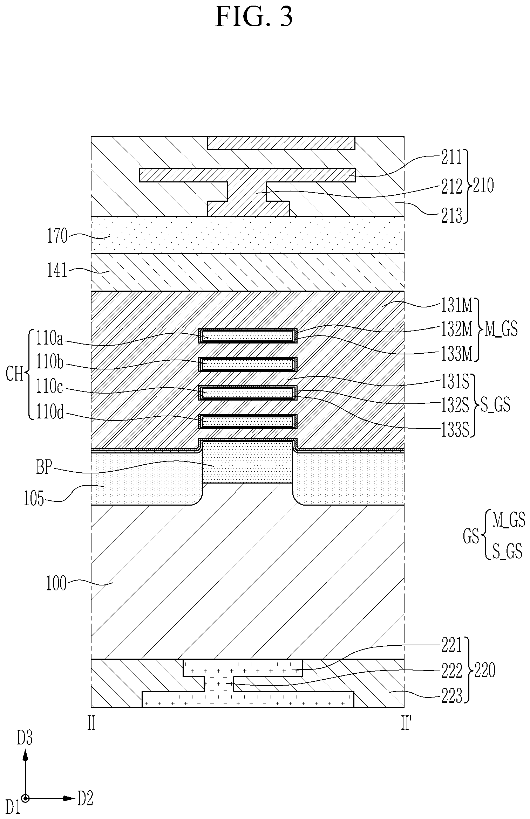

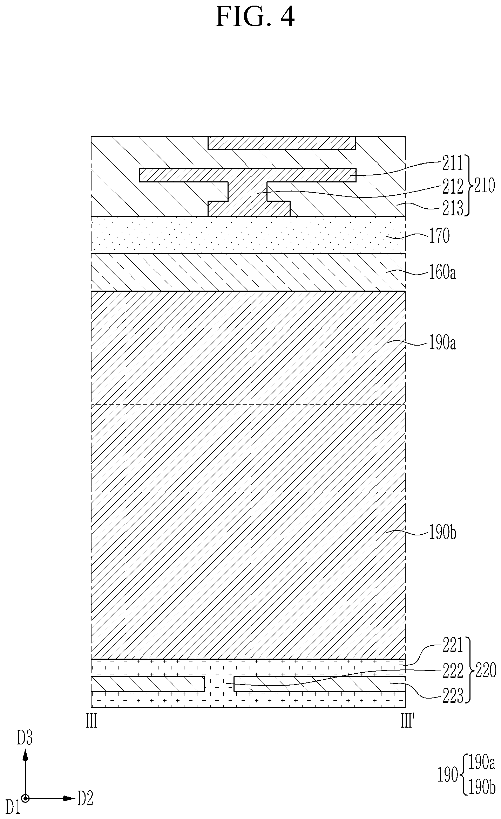

FIG. 1 is a top plan view showing a semiconductor device according to an embodiment. FIG. 2 to FIG. 4 are cross-sectional views showing a semiconductor device according to an embodiment. Specifically, FIG. 2 is a cross-sectional view of a semiconductor device taken along line I-I' of FIG. 1. FIG. 3 is a cross-sectional view of a semiconductor device taken along line II-II' of FIG. 1. FIG. 4 is a cross-sectional view of a semiconductor device taken along line III-III' of FIG. 1.

Referring to FIG. 1 to FIG. 4, a semiconductor device according to an embodiment may include a base insulation layer 100, channel layers CH positioned on a first surface of the base insulation layer 100, source/drain patterns 150 positioned at both sides of the channel layers CH, gate structures M_GS and S_GS surrounding the channel layers CH, a lower wire structure 220 positioned on a second surface of the base insulation layer 100, and a through electrode 190 spaced apart from a gate structure GS interposing a first source/drain pattern 151.

The base insulation layer 100 may include, for example, a layer of oxide, nitride, nitride oxide, or a combination thereof. The base insulation layer 100 may include an insulating material. For example, the base insulation layer 100 may include silicon nitride (SiN). Although it is illustrated that the base insulation layer 100 is a single layer, this is merely for the convenience of explanation, and it is not limited thereto. The first surface and the second surface of the base insulation layer 100 may be formed as a plane parallel to a first direction D1 and a second direction D2 crossing the first direction D1. For example, the first surface of the base insulation layer 100 may be an upper surface, and the second surface may be a bottom surface. An upper surface of the base insulation layer 100 is a surface opposite to a bottom surface of the base insulation layer 100 in a third direction D3. The third direction D3 may be a direction perpendicular to the first direction D1 and the second direction D2. The bottom surface of the base insulation layer 100 may be referred to as a backside of the base insulation layer 100. In some embodiments, a logic circuit in a cell region may be implemented on the upper surface of the base insulation layer 100. The base insulation layer 100 may include a device isolation trench STI.

The channel layer CH may be disposed on the base insulation layer 100. In an embodiment, a plurality of channel layers 110a, 110b, 110c, and 110d may be disposed on the base insulation layer 100. For example, each of the plurality of channel layers 110a, 110b, 110c, and 110d may be a semiconductor layer of a sheet shape. Each semiconductor layer may be a nanosheet having a thickness of several nanometers along the third direction D3.

The channel layer CH may provide a passage through which current flows between two source/drain patterns 150. Referring to FIG. 2 and FIG. 3, the channel layers 110a, 110b, 110c, and 110d may be disposed between or adjacent to the source/drain patterns 150, and connect source/drain patterns 150. The channel layers 110a, 110b, 110c, and 110d may penetrate a portion of the gate structure GS in a direction (e.g., the first direction D1) crossing the direction along which the gate structure GS extends. The channel layers 110a, 110b, 110c, and 110d may be arranged to be spaced apart from the upper surface of the base insulation layer 100 in a vertical direction (e.g., the third direction D3). In FIG. 2 and FIG. 3, it is illustrated that four channel layers 110a, 110b, 110c, and 110d are disposed to be spaced apart, but it is not limited thereto, and the number of stacked channel layers CH may be changed in various ways. The channel layers CH may include a semiconductor material. For example, the channel layers CH may include a group IV semiconductor such as Si and Ge, a group III-V compound semiconductor, a group II-VI compound semiconductor, or the like. In an embodiment, a lower pattern BP may be further disposed below the channel layer CH. Specifically, the lower pattern BP may be positioned between the base insulation layer 100 and a sub-gate structure S_GS positioned lowermost among a plurality of sub-gate structures S_GS. An upper surface of the lower pattern BP may contact a lower surface of the sub-gate structure S_GS positioned lowermost among the plurality of sub-gate structures S_GS. The lower pattern BP may include the same material as the channel layer CH. For example, the lower pattern BP may include a group IV semiconductor such as Si and Ge, a group III-V compound semiconductor, a group II-VI compound semiconductor, or the like. However, it is not limited thereto, and the lower pattern BP may include a material different from the channel layer CH.

As another embodiment, unlike what is shown in FIG. 2 and FIG. 3, a semiconductor device may not include the lower pattern BP. In this case, the lower surface of the sub-gate structure S_GS positioned lowermost among the sub-gate structures S_GS may directly contact the base insulation layer 100.

As another embodiment, unlike what is shown in FIG. 2 and FIG. 3, a partial region of the base insulation layer 100 overlapping the sub-gate structure S_GS in the third direction D3 may extend into an interior of the lower pattern BP, and directly contact the lower surface of the sub-gate structure S_GS positioned lowermost among the sub-gate structures S_GS. At this time, the lower pattern BP may be positioned in a lower portion of the source/drain pattern 150 positioned at both sides of the sub-gate structure S_GS, and the lower patterns BP positioned in the lower portions of different source/drain patterns 150 may be separated by the base insulation layer 100. The base insulation layer 100 may be positioned between the lower patterns BP positioned in the lower portions of the different source/drain patterns 150.

A semiconductor device according to an embodiment may further include a field insulation layer 105. The field insulation layer 105 may be positioned on the lower pattern BP. The field insulation layer 105 may be positioned on a sidewall of the lower pattern BP. The field insulation layer 105 may not be positioned on the upper surface of the lower pattern BP. The field insulation layer 105 may cover a portion of a sidewall of the lower pattern BP. In such a case, a portion of the lower pattern BP may protrude from an upper surface of the field insulation layer 105 in the third direction D3. Unlike what is shown, the field insulation layer 105 may entirely cover a side surface of the lower pattern BP. The field insulation layer 105 may include, for example, a layer of oxide, nitride, nitride oxide, or a combination thereof. Although it is illustrated that the field insulation layer 105 is a single layer, this is merely for the convenience of explanation, and it is not limited thereto.

The source/drain pattern 150 may be positioned on the base insulation layer 100. The source/drain pattern 150 may be positioned at both sides of the channel layer CH or the sub-gate structure S_GS. Specifically, the two source/drain patterns 150 may be arranged in a direction (e.g., the first direction D1) crossing the direction along which the gate structure GS extends, interposing the channel layer CH or the sub-gate structure S_GS. The source/drain pattern 150 may directly contact the channel layer CH or the sub-gate structure S_GS. The source/drain pattern 150 may directly contact a sub-interface insulation layer 133S of the sub-gate structure S_GS. Although not shown in the drawings, an inner spacer may be further disposed between the source/drain pattern 150 and the sub-interface insulation layer 133S. The inner spacer may include at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof.

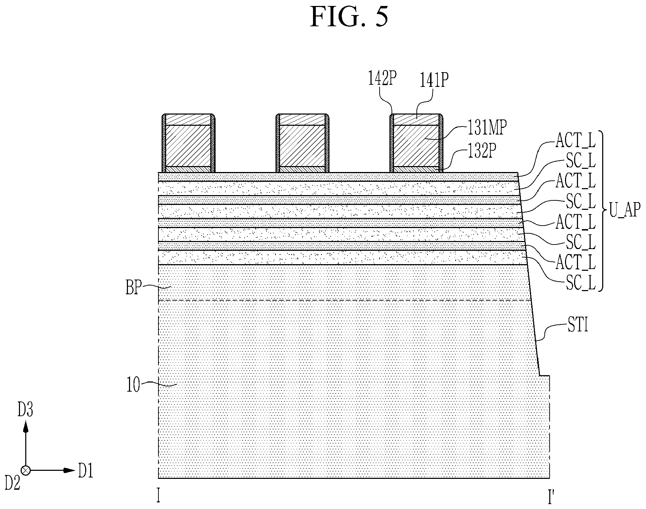

The source/drain pattern 150 may be formed as an epitaxial layer formed by selective epitaxial growth (SEG), in a region where a portion of a sacrificial layer SC_L (refer to FIG. 5) and an active pattern ACT_L (refer to FIG. 5) to be described later is recessed. That is, the source/drain patterns 150 may fill the region where a portion of the sacrificial layer SC_L (refer to FIG. 5) and the active pattern ACT_L (refer to FIG. 5) to be described later is recessed.

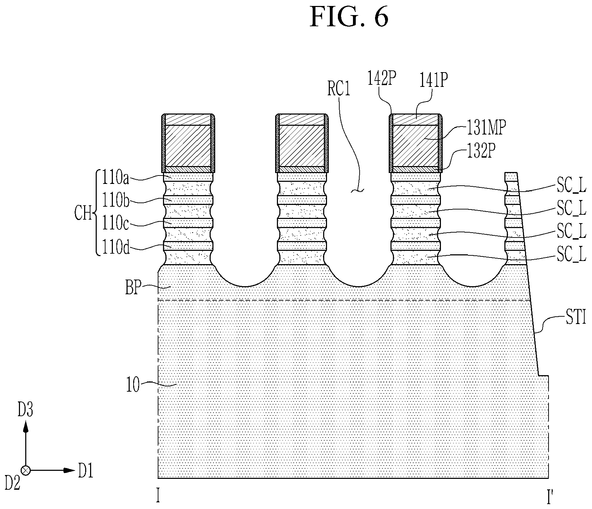

The source/drain pattern 150 may include the first source/drain pattern 151, a second source/drain pattern 152, and a third source/drain pattern 153. The first to third source/drain patterns 151, 152, and 153 may include liner layers 151a, 152a, and 153a and filling layers 151b, 152b, and 153b, respectively. The liner layers 151a, 152a, and 153a may be positioned on side surfaces and bottom surfaces of the first to third source/drain patterns 151, 152, and 153. The liner layers 151a, 152a, and 153a may directly contact the sub-gate structure S_GS and the channel layer CH. That is, the liner layers 151a, 152a, and 153a may be positioned along a surface profile of a source/drain recess RC1 (refer to FIG. 6) to be described later. The filling layers 151b, 152b, and 153b may be positioned on the liner layers 151a, 152a, and 153a. The filling layers 151b, 152b, and 153b and the liner layers 151a, 152a, and 153a may have upper surfaces of substantially the same height. That is, the filling layers 151b, 152b, and 153b may fill an interior of the source/drain recess RC1 (refer to FIG. 6) to be described later.

The source/drain pattern 150 may include a semiconductor material. The source/drain pattern 150 may include, for example, silicon or germanium. In addition, the source/drain pattern 150 may include, for example, a binary compound, or a ternary compound including at least two or more of carbon (C), silicon (Si), germanium (Ge), tin (Sn). For example, the source/drain pattern 150 may include silicon, silicon-germanium, germanium, silicon carbide, or the like, but is not limited thereto. In an embodiment, the liner layers 151a, 152a, and 153a and the filling layers 151b, 152b, and 153b may have different silicon (Si), or germanium (Ge) concentration. For example, the concentration of silicon (Si) or germanium (Ge) included in the liner layers 151a, 152a, and 153a may be smaller than the concentration of silicon (Si) or germanium (Ge) included in the filling layers 151b, 152b, and 153b.

In an embodiment, the first source/drain pattern 151 and the third source/drain pattern 153 may be connected to the lower wire structure 220. The first source/drain pattern 151 and the third source/drain pattern 153 may be connected to the lower wire structure 220 through the through electrode 190. The through electrode 190 may include a lower conductive pattern 190b and an upper conductive pattern 190a. A partial region of the first source/drain pattern 151 and the third source/drain pattern 153 may be penetrated by the lower conductive pattern 190b. For example, a portion of a side surface or a bottom surface of the first source/drain pattern 151 and the third source/drain pattern 153 may be penetrated by the lower conductive pattern 190b. A portion of side surfaces of the first source/drain pattern 151 and the third source/drain pattern 153 may be connected to the upper conductive pattern 190a described later. Accordingly, at least a partial region of the first source/drain pattern 151 and the third source/drain pattern 153 may contact the lower conductive pattern 190b and/or the upper conductive pattern 190a. The first source/drain pattern 151 and the third source/drain pattern 153 may receive electrical power from the lower wire structure 220 through the lower conductive pattern 190b and/or the upper conductive pattern 190a.

In an embodiment, the second source/drain pattern 152 may be connected to an upper wire structure 210 to be described later. The second source/drain pattern 152 may be connected to the upper wire structure 210 through a contact electrode 180. A portion of an upper surface of the second source/drain pattern 152 may be connected to a portion of the contact electrode 180. In an embodiment, the current having passed through the channel layer CH may be transferred to the upper wire structure 210 through the second source/drain pattern 152 and the contact electrode 180. Referring to FIG. 2, although a filling layer 152b of the second source/drain pattern 152 is illustrated to be connected to the contact electrode 180, the contact electrode 180 may also be connected to a liner layer 152a of the second source/drain pattern 152.

The gate structure GS may be disposed on the base insulation layer 100. The gate structure GS may include the sub-gate structure S_GS and a main gate structure M_GS. The sub-gate structure S_GS may be disposed on the base insulation layer 100, and the main gate structure M_GS may be disposed on the sub-gate structure S_GS. On the base insulation layer 100, the gate structure GS may extend in a different direction other than the direction along which the source/drain patterns 150 are arranged. For example, on the base insulation layer 100, the gate structure GS may extend in a direction (e.g., the second direction D2) crossing the direction along which the source/drain patterns 150 are arranged. The gate structure GS may be positioned on the base insulation layer 100. The gate structures GS may be arranged to be spaced apart in the first direction D1. The main gate structure M_GS may be positioned on a channel layer 110a positioned uppermost. The main gate structure M_GS may also be positioned on a side surface of the structure in which the channel layers 110a, 110b, 110c, and 110d and the sub-gate structures S_GS are stacked. That is, the main gate structure M_GS may surround each of the channel layers 110a, 110b, 110c, and 110d together with the sub-gate structures S_GS. However, the main gate structure M_GS may not be positioned on a surface where each channel layers 110a, 110b, 110c, and 110d contacts the source/drain pattern 150. In FIG. 2 and FIG. 3, it is illustrated that four sub-gate structures S_GS are arranged in the third direction, but the number of the arranged sub-gate structures S_GS is not limited thereto. For example, the gate structure GS may include three sub-gate structures S_GS.

The sub-gate structures S_GS may contact the source/drain pattern 150. For example, the sub-gate structure S_GS may directly contact the source/drain pattern 150. The sub-gate structures S_GS may be positioned at both sides of the source/drain pattern 150. The sub-gate structures S_GS each may be formed in multiple layers. For example, the sub-gate structures S_GS each may include a sub-gate electrode 131S, a sub-gate insulation layer 132S and the sub-interface insulation layer 133S. The sub-gate structures S_GS and the channel layers 110a, 110b, 110c, and 110d may be alternately stacked in the third direction D3. The sub-gate structures S_GS may surround surfaces of the channel layers 110a, 110b, 110c, and 110d other than surfaces connected to the source/drain pattern 150, together with the main gate structure M_GS.

The sub-gate electrode 131S may include at least one of a metal, a metal alloy, a conductive metal nitride, a metal silicide, a doped semiconductor material, a conductive metal oxide, and a conductive metal nitride oxide. The sub-gate electrode 131S may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn), vanadium (V), and a combination thereof, but is not limited thereto. The conductive metal oxide and the conductive metal nitride oxide may include oxidized forms of the above-mentioned materials, but is not limited thereto.

The sub-interface insulation layer 133S may be positioned along a circumference of the channel layer CH. For example, the sub-interface insulation layer 133S may surround surfaces of the channel layer CH other than the surface connected to the source/drain pattern 150. The sub-interface insulation layer 133S may directly contact the source/drain pattern 150 and the channel layer CH. The sub-interface insulation layer 133S may be interposed between the channel layer CH and the sub-gate insulation layer 132S. The sub-interface insulation layer 133S may include, for example, silicon oxide (SiO₂).

The sub-gate insulation layer 132S may extend along an upper surface of the sub-interface insulation layer 133S. The sub-gate insulation layer 132S may surround the channel layer CH. For example, the sub-gate insulation layer 132S may surround surfaces of the channel layer CH other than the surface connected to the source/drain pattern 150. The sub-gate insulation layer 132S may be positioned along the circumference of the channel layer CH. The sub-gate insulation layer 132S may be interposed between the sub-gate electrode 131S and the sub-interface insulation layer 133S. The sub-gate insulation layer 132S may include, for example, high dielectric constant material. High dielectric constant material may include a material having a higher dielectric constant than silicon oxide (SiO₂) such as hafnium oxide (HfO), aluminum oxide (AlO), or tantalum oxide (TaO).

The main gate structure M_GS may be positioned on the sub-gate structure S_GS and the channel layer CH. The main gate structure M_GS may be positioned on an upper surface of the channel layer CH. The main gate structures M_GS each may be formed in multiple layers. For example, the main gate structure M_GS may include a main gate electrode 131M, a main interface insulation layer 133M, a main gate insulation layer 132M. The main gate structure M_GS may surround surfaces of at least one (e.g., 110a)of the channel layers CH other than the surface connected to the source/drain pattern 150, together with the sub-gate structure S_GS.

The main gate electrode 131M may be positioned on the sub-gate structure S_GS and the channel layer CH. The main gate electrode 131M may be positioned on the upper surface of the channel layer CH. The main gate electrode 131M may include the same material as the sub-gate electrode 131S. For example, the main gate electrode 131M may include at least one of a metal, a metal alloy, a conductive metal nitride, a metal silicide, a doped semiconductor material, a conductive metal oxide, and a conductive metal nitride oxide.

The main interface insulation layer 133M may extend along the upper surface of the channel layer CH. The main interface insulation layer 133M may include, for example, silicon oxide (SiO₂). The main gate insulation layer 132M may extend along the side surface and the bottom surface of the main gate electrode 131M. The main gate insulation layer 132M may include, for example, high dielectric constant material.

A semiconductor device according to an embodiment may further include a capping layer 141 and a gate spacer 142. The gate spacer 142 may be positioned on a side surface of the main gate electrode 131M. The gate spacer 142 may not be disposed between the lower pattern BP and the channel layer CH. The gate spacer 142 may not be disposed between the channel layers CH adjacent in the third direction D3. Although the gate spacer 142 is illustrated as a single layer, this is merely for the convenience of explanation, and it is not limited thereto. The gate spacer 142 may include, for example, at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof.

The capping layer 141 may be positioned on the main gate structure M_GS and the gate spacer 142. Unlike what is shown, the capping layer 141 may be positioned between the gate spacers 142. The capping layer 141 may include, for example, at least one of silicon nitride (SiN), silicon nitride oxide (SiON), silicon (Si) carbonitride (SiCN), silicon carbonate nitride (SiOCN) and a combination thereof. The capping layer 141 may include a material having etch selectivity with respect to an interlayer insulation layer 170 to be described later.

The through electrode 190 may be positioned to be spaced apart from the gate structure GS, interposing the first source/drain pattern 151. The through electrode 190 may penetrate the base insulation layer 100, and electrically connect the lower wire structure 220 described later and the first source/drain pattern 151. In an embodiment, the through electrode 190 may include the upper conductive pattern 190a and the lower conductive pattern 190b.

The upper conductive pattern 190a may be positioned between the two source/drain patterns 150. The upper conductive pattern 190a may simultaneously contact the source/drain pattern 150 of two different semiconductor devices. For example, referring to FIG. 2, the upper conductive pattern 190a may simultaneously contact the first source/drain pattern 151 and the third source/drain pattern 153. The first source/drain pattern 151 and the third source/drain pattern 153 may be the source/drain pattern 150 of each of adjacent two different semiconductor devices. The upper conductive pattern 190a may extend in the third direction D3. The upper conductive pattern 190a may have an upper surface at substantially the same height as upper surfaces of the main gate structure M_GS and a dummy gate spacer 160b described later. An upper surface of the upper conductive pattern 190a may contact a lower surface of a dummy capping layer 160a described later. A lower surface of the upper conductive pattern 190a may contact an upper surface of the lower conductive pattern 190b.

In an embodiment, a width of the upper conductive pattern 190a in the first direction D1 may be smaller than a width of the lower conductive pattern 190b in the first direction D1. The width of the upper conductive pattern 190a in the first direction D1 may be substantially the same as a width of the adjacent sub-gate structure S_GS in the first direction D1.

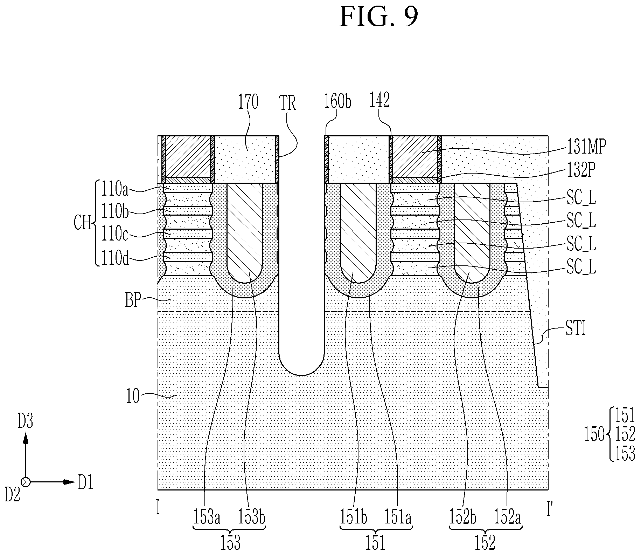

In an embodiment, the width of the upper conductive pattern 190a in the first direction D1 may be the same as a width of the channel layer CH in the first direction D1. However, it is not limited thereto, and the width of the upper conductive pattern 190a in the first direction D1 may be smaller than the width of the channel layer CH in the first direction D1. When the width of the upper conductive pattern 190a in the first direction D1 is smaller than the width of the channel layer CH in the first direction D1, a residual semiconductor material may be positioned between the upper conductive pattern 190a and the source/drain pattern 150. When the channel layer CH and a sacrificial layer SC_L are removed in the process (refer to FIG. 9) of forming the upper conductive pattern 190a described later, the residual semiconductor material may be a partial region of the channel layer CH that is not removed but remains between the source/drain pattern and a sidewall of a trench TR. The residual semiconductor material may include the same material as the channel layer CH. For example, the residual semiconductor material may include Si, or SiGe.

The upper conductive pattern 190a may include a metal or metal alloy. The upper conductive pattern 190a may include, for example, at least one of titanium (Ti), tantalum (Ta), nickel (Ni), cobalt (Co) tungsten (W), molybdenum (Mo), ruthenium (Ru) and platinum (Pt). In an embodiment, the upper conductive pattern 190a may include the same material as the lower conductive pattern 190b. The upper conductive pattern 190a may be integrally formed in the same process as the lower conductive pattern 190b.

The lower conductive pattern 190b may be positioned between the lower wire structure 220 and the upper conductive pattern 190a. The lower conductive pattern 190b may penetrate the base insulation layer 100 and extend in the third direction D3. A first end of the lower conductive pattern 190b may be connected to the lower surface of the upper conductive pattern 190a, and a second end thereof may be connected to the lower wire structure 220. A width of the lower conductive pattern 190b along the first direction D1 may be larger than an interval between the third source/drain pattern 153 and the source/drain patterns 150, for example, the first source/drain pattern 151. The lower conductive pattern 190b may overlap a partial region of the source/drain pattern 150. For example, the lower conductive pattern 190b may overlap at least a portion of the first source/drain pattern 151 and at least a portion of the third source/drain pattern 153. The lower conductive pattern 190b may penetrate a portion of a lower surface and a side surface of the source/drain pattern 150, and extend to a partial region of an interior of the source/drain pattern 150.

The upper surface of the lower conductive pattern 190b may be positioned between an upper surface of the source/drain pattern 150 and a lower surface of the source/drain pattern 150. The lower conductive pattern 190b may be positioned between the two source/drain patterns 150. The lower conductive pattern 190b may simultaneously contact the source/drain pattern 150 of two different semiconductor devices. For example, referring to FIG. 2, the lower conductive pattern 190b may simultaneously contact the first source/drain pattern 151 and the third source/drain pattern 153. The first source/drain pattern 151 and the third source/drain pattern 153 may be the source/drain pattern 150 of each of adjacent two different semiconductor devices. The upper surface of the lower conductive pattern 190b may contact the lower surface of the upper conductive pattern 190a.

The upper surface of the lower conductive pattern 190b may directly contact the lower surface of the upper conductive pattern 190a. In an embodiment, interface of the lower conductive pattern 190b and the upper conductive pattern 190a may be positioned at a higher level in the third direction D3 than the lower surface of the sub-gate structure S_GS positioned lowermost among adjacent sub-gate structures S_GS. The interface of the lower conductive pattern 190b and the upper conductive pattern 190a may be positioned at a lower level in the third direction D3 than an upper surface of the sub-gate structure S_GS positioned uppermost among adjacent sub-gate structures S_GS.

In an embodiment, the interface of the lower conductive pattern 190b and the upper conductive pattern 190a may be positioned at a higher level in the third direction D3 than the lower surface of the channel layer (e.g., 110d of FIG. 2) positioned lowermost among adjacent channel layers CH. The interface of the lower conductive pattern 190b and the upper conductive pattern 190a may be positioned at a lower level in the third direction D3 than the upper surface of the channel layer (e.g., 110a of FIG. 2) positioned uppermost among adjacent channel layers CH.

In an embodiment, the width of the lower conductive pattern 190b in the first direction D1 may be larger than the width of the upper conductive pattern 190a in the first direction D1. The width of the lower conductive pattern 190b in the first direction D1 may be larger than the width of the adjacent sub-gate structure S_GS in the first direction D1. The width of the lower conductive pattern 190b in the first direction D1 may be larger than the width of the channel layer CH in the first direction D1. The lower conductive pattern 190b may include a metal or metal alloy. The lower conductive pattern 190b may include, for example, at least one of titanium (Ti), tantalum (Ta), nickel (Ni), cobalt (Co) tungsten (W), molybdenum (Mo), ruthenium (Ru) and platinum (Pt). In an embodiment, the lower conductive pattern 190b may include the same material as the upper conductive pattern 190a. The lower conductive pattern 190b may be integrally formed in the same process as the upper conductive pattern 190a. A semiconductor device according to an embodiment may further include the dummy capping layer 160a and the dummy gate spacer 160b. The dummy capping layer 160a may be positioned on the upper conductive pattern 190a and the dummy gate spacer 160b. The dummy capping layer 160a may cover upper surfaces of the upper conductive pattern 190a and the dummy gate spacer 160b. The dummy capping layer 160a may be positioned in substantially the same layer as the capping layer 141. The dummy capping layer 160a may have an upper surface at substantially the same height as an upper surface of the capping layer 141. The dummy capping layer 160a may have a lower surface at substantially the same height as a lower surface of the capping layer 141. The dummy capping layer 160a may include the same material as the capping layer 141. The dummy capping layer 160a may include, for example, at least one of silicon nitride (SiN), silicon nitride oxide (SiON), silicon (Si) carbonitride (SiCN), silicon carbonate nitride (SiOCN) and a combination thereof. The dummy capping layer 160a may include a material having etch selectivity with respect to the interlayer insulation layer 170. The dummy capping layer 160a may be simultaneously formed with the capping layer 141, in the same process as the capping layer 141.

The dummy gate spacer 160b may be positioned on a side surface of the upper conductive pattern 190a. Specifically, the dummy gate spacer 160b may be positioned between the interlayer insulation layer 170 and the upper conductive pattern 190a. The dummy gate spacer 160b may not be positioned on the interface between the upper conductive pattern 190a and the first source/drain pattern 151. That is, in a region adjacent to the source/drain pattern 150, the dummy gate spacer 160b may have a lower surface at substantially the same height as the upper surface of the source/drain pattern 150. The dummy gate spacer 160b may have an upper surface at substantially the same height as an upper surface of the main gate structure M_GS. The dummy gate spacer 160b may be positioned in substantially the same layer as the gate spacer 142. The dummy gate spacer 160b may have an upper surface at substantially the same height as an upper surface of the gate spacer 142. The dummy gate spacer 160b may have a lower surface at substantially the same height as a lower surface of the gate spacer 142. The dummy gate spacer 160b may include the same material as the gate spacer 142. For example, the dummy gate spacer 160b may include at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof. The dummy gate spacer 160b may be simultaneously formed with the gate spacer 142, in the same process as the gate spacer 142.

The lower wire structure 220 may be disposed on the bottom surface of the base insulation layer 100. In an embodiment, the lower wire structure 220 may be a component for supplying electrical power to at least one of the source/drain patterns 150. For example, the lower wire structure 220 may be a power delivery network. The lower wire structure 220 may include lower wires 221, lower vias 222 and a lower insulation layer 223. The lower wires 221 and the lower vias 222 may be positioned on the bottom surface of the base insulation layer 100. The lower wires 221 and the lower vias 222 may include a metal (e.g., copper). The lower insulation layer 223 may be positioned on the bottom surface of the base insulation layer 100. The lower insulation layer 223 may be disposed between the bottom surface of the base insulation layer 100, the lower wires 221 and the lower vias 222 and insulate them. That is, the lower insulation layer 223 may cover the lower wires 221 and the bottom surface of the base insulation layer 100. A lower wire 221 and the lower vias 222 may be positioned within the lower insulation layer 223. The lower insulation layer 223 may include, for example, at least one of silicon oxide (SiO₂), silicon nitride (SiN), silicon nitride oxide (SiON), or low dielectric layers.

In an embodiment, the semiconductor device may further include the interlayer insulation layer 170, the upper wire structure 210 and the contact electrode 180.

The interlayer insulation layer 170 may cover the channel layer CH, the gate structure GS, the source/drain pattern 150, and the through electrode 190. The interlayer insulation layer 170 may include, for example, at least one of silicon oxide (SiO₂), silicon nitride (SiN), silicon nitride oxide (SiON), and a low dielectric constant material. Low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), fluoride silicate glass (FSG), polyimide nanofoams such as polypropylene oxide, carbon-doped silicon oxide (CDO), organo-silicate glass (OSG), SiLK, Amorphous Fluorinated Carbon, silica aerogels, silica xerogels, mesoporous silica or a combination thereof, but is not limited thereto. In an embodiment, the interlayer insulation layer 170 may include a different material from the base insulation layer 100.

The upper wire structure 210 may be positioned on the interlayer insulation layer 170. The upper wire structure 210 may include upper wires 211, upper vias 212 and an upper insulation layer 213. The upper wires 211 and the upper vias 212 may include a metal (e.g., copper). The upper insulation layer 213 may be disposed between the upper wires 211 and the upper vias 212 and insulate them. The upper insulation layer 213 may cover the interlayer insulation layer 170 and the upper wires 211. The upper wires 211 and the upper vias 212 may be positioned within the upper insulation layer 213. The upper insulation layer 213 may include, for example, at least one of silicon oxide (SiO₂), silicon nitride (SiN), silicon nitride oxide (SiON), or low dielectric layers.

The contact electrode 180 may be positioned between the upper wire structure 210 and a first one among the source/drain patterns 150. The contact electrode 180 may include a first via 180a and a second via 180b. The contact electrode 180 may penetrate the interlayer insulation layer 170 in the third direction D3. The first via 180a may contact the upper surface of the second source/drain pattern 152. The first via 180a may extend in the third direction D3. The first via 180a may have an upper surface at a height the same as or higher than the upper surface of the capping layer 141. The second via 180b may be positioned on the first via 180a. A first end of the second via 180b may directly contact the first via 180a. A second end of the second via 180b may directly contact the upper wire structure 210. The first via 180a and the second via 180b may include at least one of a metal, a metal alloy, a conductive metal nitride, a conductive metal carbide, a conductive metal oxide, a conductive metal carbonitride, and a 2-dimensional material. The metal may include, titanium (Ti), at least one of tantalum (Ta), tungsten (W), nickel (Ni), cobalt (Co) and platinum (Pt). The conductive metal nitride may include at least one of titanium nitride (TiN), tantalum nitride (TaN), tungsten nitride (WN), nickel nitride (NiN), cobalt nitride (CoN) and platinum nitride (PtN).

FIG. 5 to FIG. 24 are drawings for explaining a method of manufacturing a semiconductor device according to an embodiment.

As shown in FIG. 5, the lower pattern BP and an upper pattern structure U_AP may be formed on a substrate 10. The substrate 10 may be silicon-on-insulator (SOI) or bulk silicon. Alternatively, the substrate 10 may be silicon substrate, and may include other materials, for example, silicon germanium (SiGe), Silicon-Germanium on Insulator (SGOI), indium antimonide, lead tellurium compound, indium arsenic, indium phosphide, gallium arsenide or gallium antimonide, but is not limited thereto. The lower pattern BP may be a portion of the substrate 10.

The upper pattern structure U_AP may be positioned on the lower pattern BP. The upper pattern structure U_AP may include the sacrificial layer SC_L and the active pattern ACT_L alternately stacked on the lower pattern BP. For example, the sacrificial layer SC_L may include silicon germanium (SiGe). The active pattern ACT_L may include silicon (Si).

Subsequently, on the upper pattern structure U_AP, a preliminary gate insulation layer 132P, a preliminary main gate electrode 131MP and a preliminary capping layer 141P are formed. The preliminary gate insulation layer 132P may include, for example, silicon oxide (SiO₂), but is not limited thereto. The preliminary main gate electrode 131MP may include, for example, polysilicon, but is not limited thereto. The preliminary capping layer 141P may include, for example, silicon nitride, but is not limited thereto. On both side surfaces of the preliminary main gate electrode 131MP, a preliminary gate spacer 142P may be formed.

As shown in FIG. 6, by using a preliminary capping layer 141P and the preliminary gate spacer 142P as a mask, the source/drain recess RC1 is formed by etching at least a portion of the upper pattern structure U_AP. As the source/drain recess RC1 is formed, at least a portion of the lower pattern BP may be etched. A portion of the source/drain recess RC1 may be formed within the substrate 10. Meanwhile, as shown in FIG. 6, after forming the source/drain recess RC1, indent process with respect to the sacrificial layer SC_L may be performed. In the indent process, the sacrificial layer SC_L is etched by the wet etching or dry etching method, and accordingly, the length of the sacrificial layer SC_L in the first direction D1 may be further reduced. Accordingly, the surface of the sacrificial layer SC_L contacting the source/drain recess RC1 may have a concave shape toward the source/drain recess RC1.

As the source/drain recess RC1 is formed, the active pattern ACT_L are separated such that the channel layers 110a, 110b, 110c, and 110d may be formed. The channel layers 110a, 110b, 110c, and 110d may be positioned at both sides of the source/drain recess RC1. The channel layers 110a, 110b, 110c, and 110d and sacrificial patterns SC_L may be alternately stacked in the third direction D3. At this time, lengths of the channel layers 110a, 110b, 110c, and 110d may be different, and may be the same.

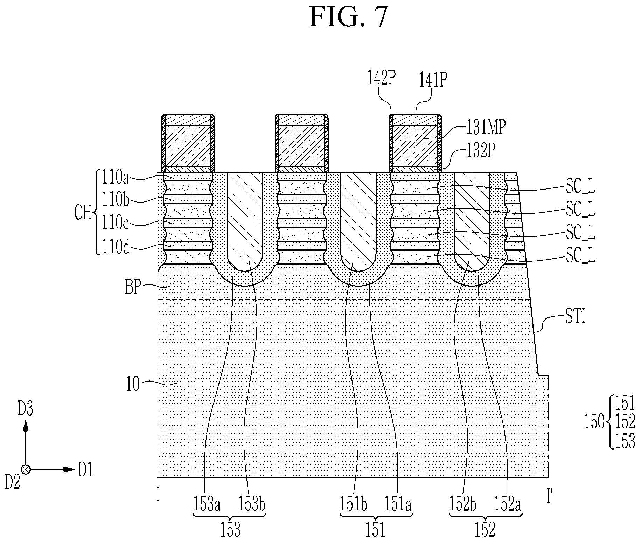

As shown in FIG. 7, the source/drain pattern 150 may be formed within the source/drain recess RC1. The source/drain pattern 150 may be formed on the substrate 10. The source/drain pattern 150 may be formed by using an epitaxial growth method. At this time, the inner wall of the source/drain recess may be used as a seed. The source/drain pattern 150 may directly contact the substrate 10 or the lower pattern BP. The source/drain pattern 150 may directly contact the channel layers 110a, 110b, 110c, and 110d and sacrificial layers SC_L. The source/drain pattern 150 may include silicon (Si), germanium (Ge) or silicon germanium (SiGe). The source/drain pattern 150 may be formed of several regions having different concentrations. For example, referring to FIG. 7, each of source/drain patterns 151, 152, and 153 may include the liner layers 151a, 152a, and 153a and the filling layers 151b, 152b, and 153b. First, the liner layers 151a, 152a, and 153a are formed along the sidewall and bottom surface of the source/drain recess RC1, and the filling layers 151b, 152b, and 153b may be formed on each of the liner layers 151a, 152a, and 153a. The liner layers 151a, 152a, and 153a and the filling layers 151b, 152b, and 153b may be formed by using an epitaxial growth method, respectively. The liner layers 151a, 152a, and 153a and the filling layers 151b, 152b, and 153b may include a semiconductor material. For example, the liner layers 151a, 152a, and 153a and the filling layers 151b, 152b, and 153b may include silicon (Si) or germanium (Ge), which are elemental semiconductor materials. In an embodiment, the liner layers 151a, 152a, and 153a and the filling layers 151b, 152b, and 153b may have different silicon (Si), or germanium (Ge) concentration. For example, the concentration of silicon (Si) or germanium (Ge) included in the liner layers 151a, 152a, and 153a may be smaller than the concentration of silicon (Si) or germanium (Ge) included in the filling layers 151b, 152b, and 153b.

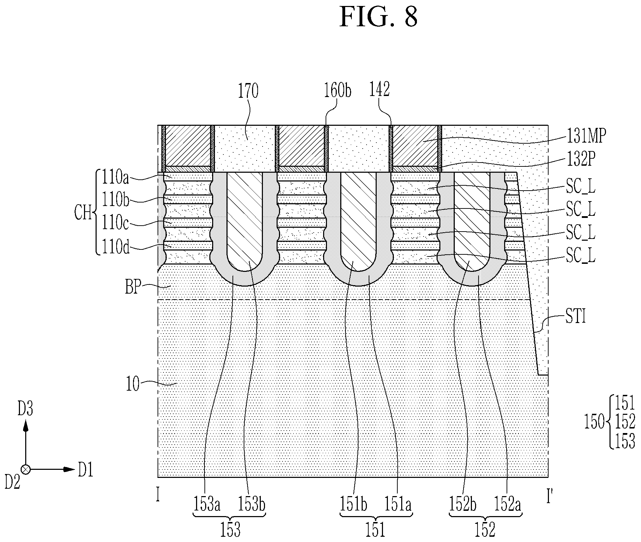

As shown in FIG. 8, the interlayer insulation layer 170 may be formed on the source/drain pattern 150. Subsequently, a portion of the interlayer insulation layer 170 and the preliminary capping layer 141P may be removed, so as to expose an upper surface of the preliminary main gate electrode 131MP. At this time, a portion of the preliminary gate spacer 142P may be removed together, such that the gate spacer 142 and the dummy gate spacer 160b may be formed. The gate spacer 142 and the dummy gate spacer 160b may be simultaneously formed.

As shown in FIG. 9, the trench TR may be formed by etching a portion of the channel layer CH and a portion of the sacrificial layer SC_L. A portion of the channel layer CH and a portion of the sacrificial layer SC_L that are removed may be a partial region of the channel layer CH and a partial region of the sacrificial layer SC_L positioned between the source/drain patterns 150 of adjacent two semiconductor devices. For example, in FIG. 9, a partial region of the channel layer CH and a partial region of the sacrificial layer SC_L positioned between the first source/drain pattern 151 and the third source/drain pattern 153 may be removed. At this time, the preliminary gate insulation layer 132P and the preliminary main gate electrode 131MP positioned on the channel layer CH and the sacrificial layer SC_L that are removed may also be removed together. However, even in this case, the dummy gate spacer 160b may not be removed. The trench TR may penetrate the channel layer CH and the sacrificial layer SC_L, and extend in the third direction D3. That is, compared to a bottom surface of the source/drain pattern 150, the bottom surface of the trench TR may be positioned closer to a bottom surface of the substrate 10. While a partial region of the channel layer CH, a partial region of the sacrificial layer SC_L, a portion of the preliminary gate insulation layer 132P, and a portion of the preliminary main gate electrode 131MP, positioned between the source/drain patterns 150 of adjacent two semiconductor devices, are removed, a remaining region may be covered by a separate mask pattern. In an embodiment, the channel layer CH, the sacrificial layer SC_L, the preliminary gate insulation layer 132P and the preliminary main gate electrode 131MP that are removed may be removed by a dry etching process. However, it is not limited thereto, and all or part of the channel layer CH, the sacrificial layer SC_L, the preliminary gate insulation layer 132P and the preliminary main gate electrode 131MP that are removed may be removed by a wet etching process. Referring to FIG. 9, after forming the trench TR, between the first source/drain pattern 151 and the sidewall of the trench TR and between the third source/drain pattern 153 and the sidewall of the trench TR, a partial region of the channel layer CH may remain by not being removed.

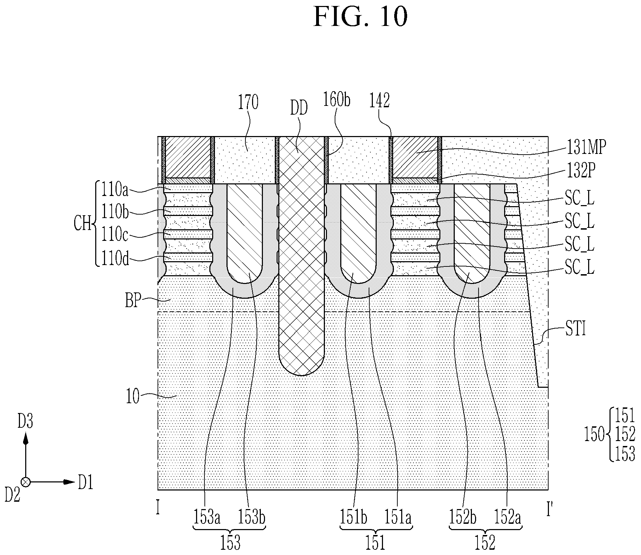

As shown in FIG. 10, the trench TR may be filled with a dummy insulation pattern DD. The dummy insulation pattern DD may include an insulating material. For example, the dummy insulation pattern DD may include silicon oxynitride (SiON) or silicon nitride (SiN). After the dummy insulation pattern DD is filled in the trench TR, the process for planarizing an upper surface of the dummy insulation pattern DD may be additionally performed. For example, the upper surface of the dummy insulation pattern DD may be planarized by a chemical mechanical polishing (CMP) process.

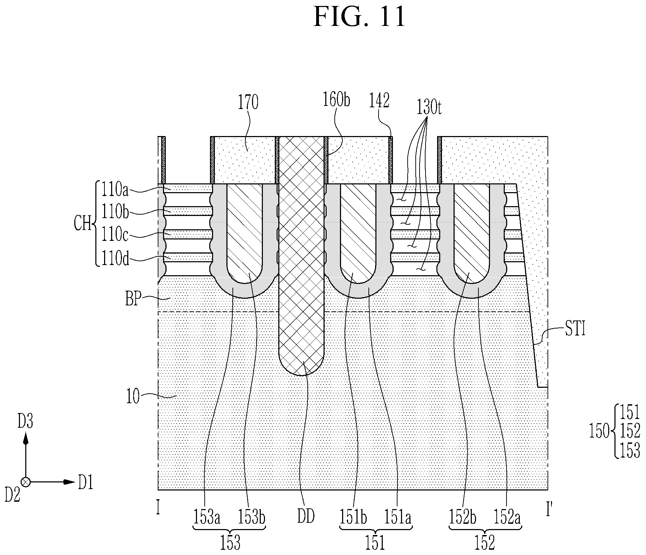

As shown in FIG. 11, after forming the dummy insulation pattern DD, remaining preliminary gate insulation layers 132P and the preliminary main gate electrode 131MPs may be removed, such that the upper pattern structure U_AP between the gate spacers 142 may be exposed. Subsequently, the sacrificial layer SC_L between the channel layer CH and the lower pattern BP may be remove, and thereby a gate trench 130t may be formed.

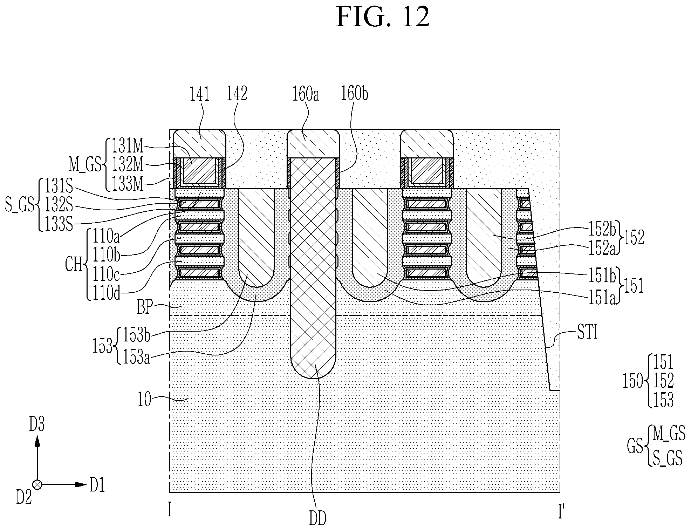

As shown in FIG. 12, the sub-interface insulation layer 133S, the sub-gate insulation layer 132S, the sub-gate electrode 131S may be sequentially formed within the gate trench 130t. In addition, the main interface insulation layer 133M, the main gate insulation layer 132M, the main gate electrode 131M, and the capping layer 141 may be sequentially formed. The sub-interface insulation layer 133S and the main interface insulation layer 133M may be simultaneously formed in the same process. The sub-gate insulation layer 132S and the main gate insulation layer 132M may be simultaneously formed in the same process. The sub-gate electrode 131S and the main gate electrode 131M may be simultaneously formed in the same process.

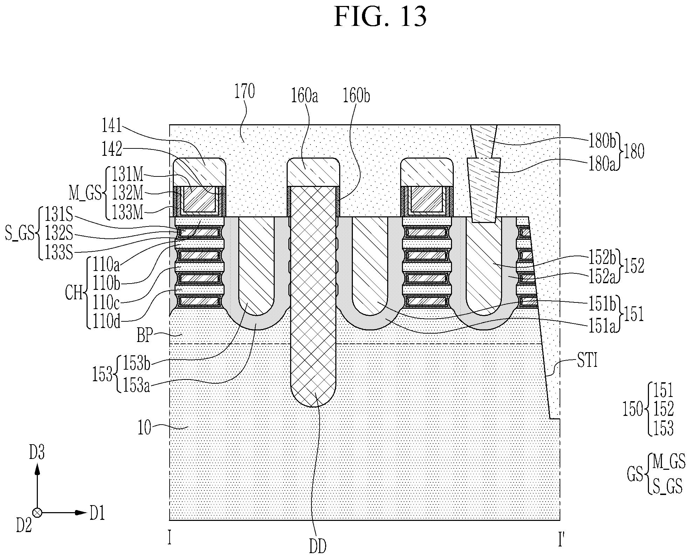

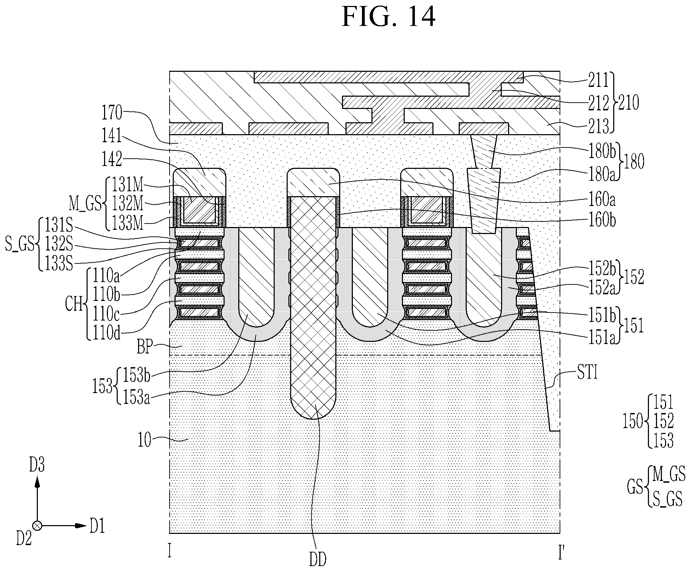

As shown in FIG. 13, a portion of the interlayer insulation layer 170 may be patterned, and thereby the contact electrode 180 of which the first end contacts the upper surface of the second source/drain pattern 152 may be formed. Specifically, after etching a portion of the interlayer insulation layer 170 overlapping the second source/drain pattern 152 in the third direction D3, the first via 180a may be formed. At this time, by using an etchant having a higher etch selectivity with respect to the interlayer insulation layer 170 compared to the source/drain pattern 150, a portion of the interlayer insulation layer 170 may be etched. Accordingly, a portion of the upper surface of the second source/drain pattern 152 may be exposed. Another in an embodiment, a portion of the interlayer insulation layer 170 may be etched by a dry etching process. A first end of the first via 180a may directly contact the upper surface of the second source/drain pattern 152. A second end of the first via 180a may directly contact the second via 180b to be formed later. Thereafter, the interlayer insulation layer 170 may be additionally formed at a higher level than the upper surface of the capping layer 141. At this time, the additionally formed interlayer insulation layer 170 may include the same insulating material as the interlayer insulation layer 170 that has been already formed on the source/drain pattern 150. Accordingly, between the interlayer insulation layer 170 formed later and the interlayer insulation layer 170 having been already formed, a boundary may not be visible. Thereafter, after etching a portion of the interlayer insulation layer 170 overlapping the first via 180a in the third direction D3, the second via 180b may be formed. The first end of the second via 180b may be connected to the second end of the first via 180a. The second end of the second via 180b may be connected to the upper wire structure 210 (refer to FIG. 14) to be formed later.

As shown in FIG. 14, on the interlayer insulation layer 170 and the contact electrode 180, the upper wire structure 210 may be formed. The upper wire structure 210 may include the upper wires 211, the upper vias 212 and the upper insulation layer 213. In an embodiment, the upper wire structure 210 may include the upper wires 211 of various layers formed through a plurality of repeated processes. First, after one layer of the upper insulation layer 213 is deposited on an upper surface of the interlayer insulation layer 170, it is patterned, and the upper wire 211 connected to the second via 180b may be formed. Thereafter, after one layer of the upper insulation layer 213 is deposited again, it is patterned, and the upper via 212 may be formed on the upper wire 211 connected to the second via 180b. Thereafter, the upper wire 211 connected to a second end of the upper via 212 may be formed. The upper wires 211 and the upper vias 212 may include a metal (e.g., copper). The upper insulation layer 213 may be positioned on the upper surface of the interlayer insulation layer 170. The upper insulation layer 213 may cover the upper wires 211 and the upper vias 212. That is, the upper wires 211 and the upper vias 212 may be disposed within the upper insulation layer 213. The upper insulation layer 213 may include, for example, at least one of silicon oxide (SiO₂), silicon nitride (SiN), silicon nitride oxide (SiON), or low-k dielectric layers.

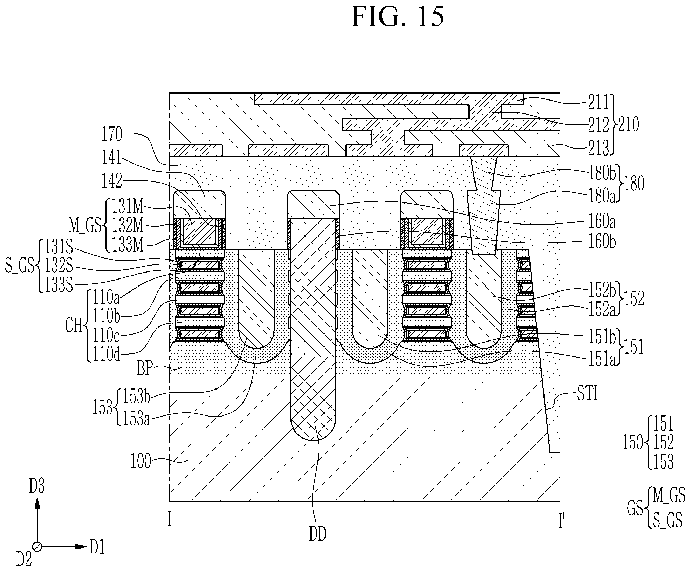

As shown in FIG. 15, the substrate 10 may be removed by performing an etching process. At this time, the process of thinning the substrate 10 by performing a chemical mechanical polishing (CMP) process with respect to a lower surface of the substrate 10 may be additionally performed. The etching process of removing the substrate 10 may be performed, for example, by a wet etching method. In this case, the substrate 10 may be etched by using an etchant having higher etch selectivity with respect to the substrate 10 compared to the dummy insulation pattern DD. However, but is not limited thereto, the substrate 10 may be removed by a dry etching process. As a partial region of the substrate 10 is removed, the dummy insulation pattern DD may be exposed. Subsequently, in the region where the substrate 10 is removed, the base insulation layer 100 covering the dummy insulation pattern DD may be formed. In an embodiment, the base insulation layer 100 may include an insulating material different from the interlayer insulation layer 170. In an embodiment, the base insulation layer 100 may include a different insulating material from the dummy insulation pattern DD. For example, the base insulation layer 100 may include silicon oxide (SiOx).

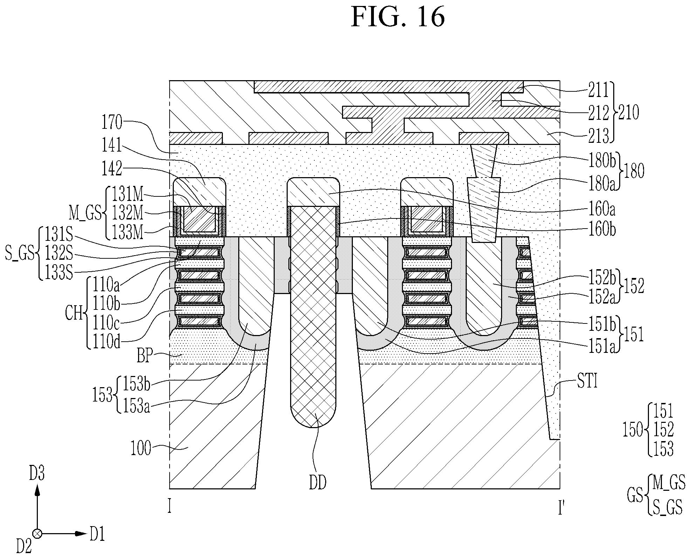

As shown in FIG. 16, by performing a photo and etching process, the base insulation layer 100 overlapping the dummy insulation pattern DD in the third direction D3, the lower pattern BP surrounding the dummy insulation pattern DD, and at least a portion of the source/drain pattern 150 may be etched. The base insulation layer 100, a portion of the lower pattern BP and the source/drain pattern 150 may be sequentially removed. For example, a portion of the base insulation layer 100 overlapping the dummy insulation pattern DD in the third direction D3 may be first etched, and accordingly, a portion of the dummy insulation pattern DD may be exposed. At this time, a portion of the base insulation layer 100 may be etched by using an etchant having a higher etch selectivity with respect to the base insulation layer 100 compared to the dummy insulation pattern DD. Subsequently, a portion of the lower pattern BP, first and third source/drain patterns 151 and 153 may be etched. At this time, the lower pattern BP, a portion of the lower pattern BP, the first and third source/drain patterns 151 and 153 may be etched by using an etchant having a higher etch selectivity with respect to the first and third source/drain patterns 151 and 153 compared to the dummy insulation pattern DD. A portion of the etched first and third source/drain patterns 151 and 153 may include a portion of sidewalls and bottom surfaces of the first and third source/drain patterns 151 and 153, respectively. After the etching is completed, an upper surface of the etched region may be positioned between upper surfaces of the first and third source/drain patterns 151 and 153 and lower surfaces of the first and third source/drain patterns 151 and 153. In an embodiment, width of the etched region in the first direction D1 may be larger than a width of the dummy insulation pattern DD in the first direction.

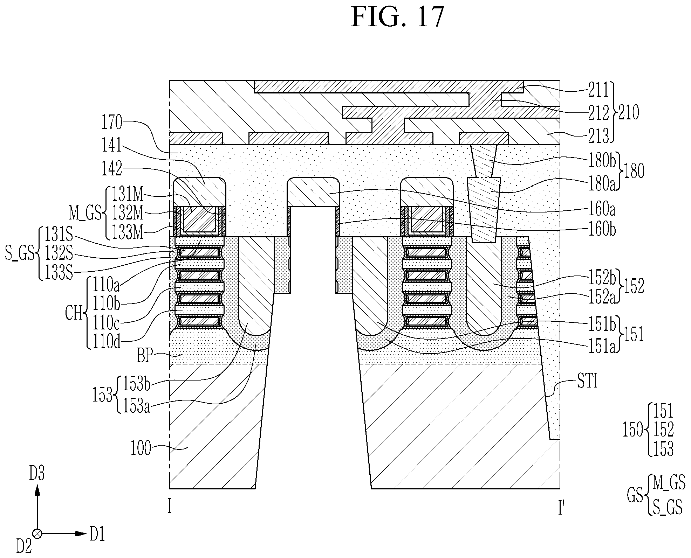

As shown in FIG. 17, the dummy insulation pattern DD exposed by the etching process may be removed. At this time, by using an etchant having a higher etch selectivity with respect to the dummy insulation pattern DD compared to the base insulation layer 100, the lower pattern BP and the source/drain pattern 150, the dummy insulation pattern DD may be etched.

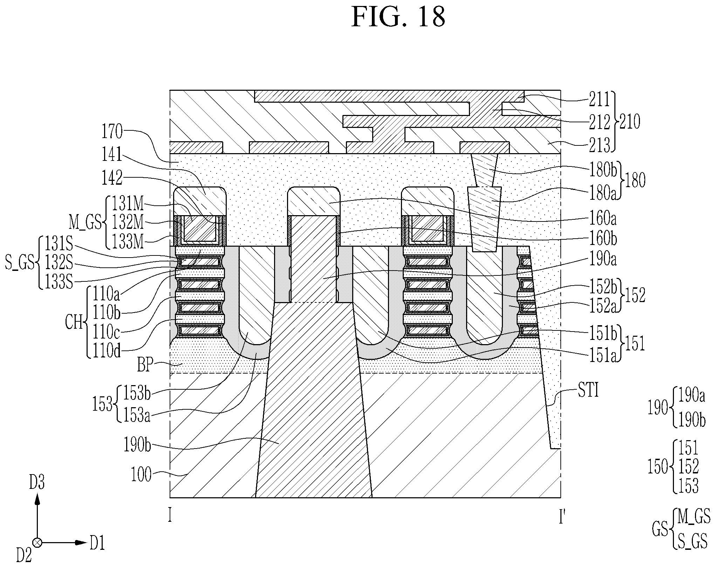

As shown in FIG. 18, the upper conductive pattern 190a and the lower conductive pattern 190b may be formed in the region where the dummy insulation pattern DD is removed and the region where the base insulation layer 100, the lower pattern BP, and the first and third source/drain patterns 151 and 153 are removed. Referring to FIG. 18, it is illustrated as if the upper conductive pattern 190a and the lower conductive pattern 190b are separate configurations, but the upper conductive pattern 190a and the lower conductive pattern 190b may be integrally formed in the same process. The upper conductive pattern 190a and the lower conductive pattern 190b may include the same material. The upper conductive pattern 190a and the lower conductive pattern 190b may include a metal or metal alloy. For example, the upper conductive pattern 190a and the lower conductive pattern 190b may include at least one of titanium (Ti), tantalum (Ta), nickel (Ni), cobalt (Co) tungsten (W), molybdenum (Mo), ruthenium (Ru) and platinum (Pt).

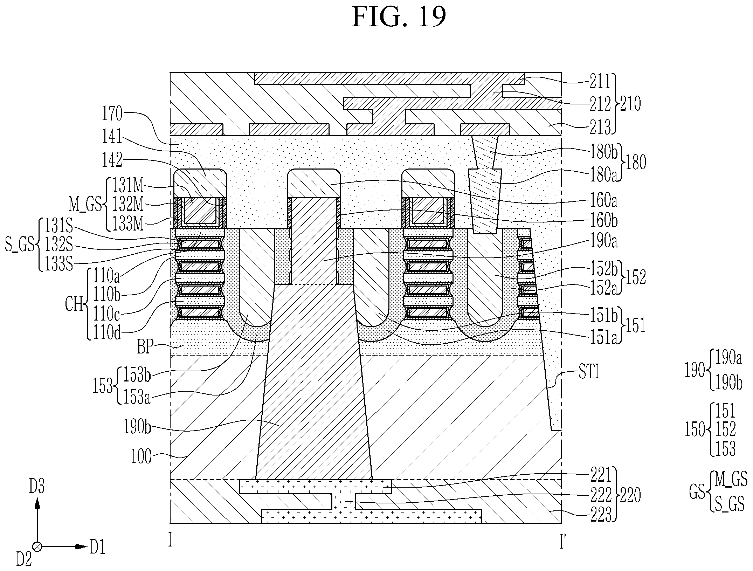

As shown in FIG. 19, the lower wire structure 220 may be formed on a lower surface of the base insulation layer 100. In an embodiment, the lower wire structure 220 may include the lower wires 221 of various layers formed through a plurality of repeated processes. First, after one layer of the lower insulation layer 223 is deposited on the bottom surface of the base insulation layer 100, it is patterned, and the lower wire 221 connected to the lower conductive pattern 190b may be formed. Thereafter, after one layer of the lower insulation layer 223 is deposited again, it is patterned, and a lower via 222 may be formed on the lower wire 221 connected to the lower conductive pattern 190b. Thereafter, the lower wire 221 connected to a second end of the lower via 222 may be formed. The lower wires 221 and the lower vias 222 may include a metal (e.g., copper). The lower insulation layer 223 may be positioned on the bottom surface of the base insulation layer 100. The lower insulation layer 223 may cover the lower wires 221 and the lower vias 222. That is, the lower wires 221 and the lower vias 222 may be disposed within the lower insulation layer 223. The lower insulation layer 223 may include, for example, at least one of silicon oxide (SiO₂), silicon nitride (SiN), silicon nitride oxide (SiON), or low-k dielectric layers.

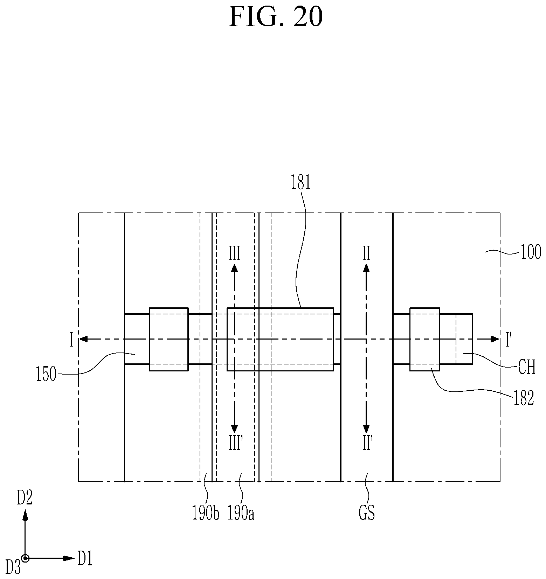

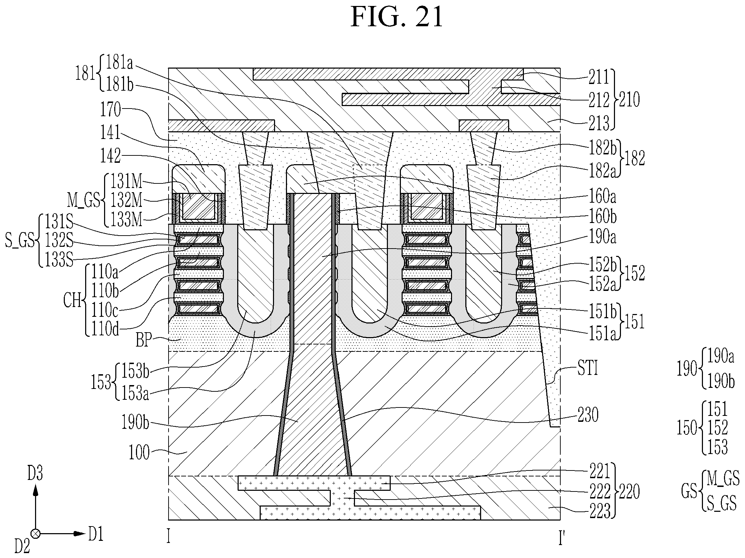

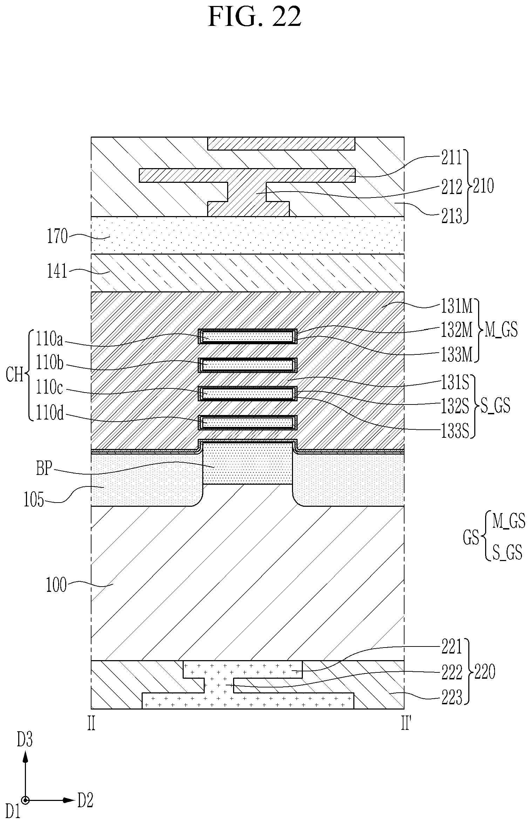

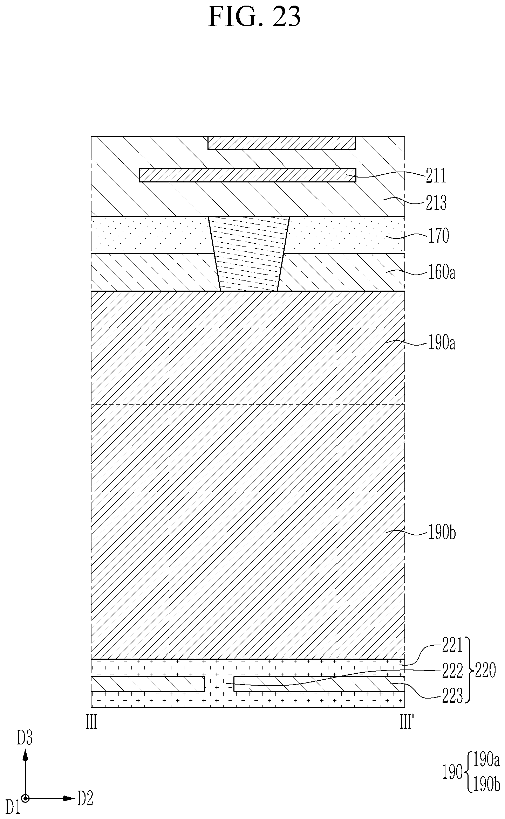

FIG. 20 is a top plan view showing a semiconductor device according to an embodiment. FIG. 21 to FIG. 23 are cross-sectional views showing a semiconductor device according to an embodiment. Specifically, FIG. 21 is a cross-sectional view of a semiconductor device taken along line I-I' of FIG. 20. FIG. 22 is a cross-sectional view of a semiconductor device taken along line II-II' of FIG. 20. FIG. 23 is a cross-sectional view of a semiconductor device taken along line III-III' of FIG. 20. The semiconductor device disclosed in FIG. 20 to FIG. 23 is substantially similar to the semiconductor device described with reference to FIG. 1 to FIG. 4, and hereinafter, the explanation is focused on differences between the semiconductor device disclosed in FIG. 20 to FIG. 23 and the semiconductor device described with reference to FIG. 1 to FIG. 4.

Referring to FIG. 20 to FIG. 23, a semiconductor device according to an embodiment may include the base insulation layer 100, the channel layers CH positioned on the first surface of the base insulation layer 100, the source/drain patterns 150 positioned at the both sides of the channel layers CH, gate structures M_GS and S_GS surrounding the channel layer CH, the lower wire structure 220 positioned on the second surface of the base insulation layer 100, and the through electrode 190 positioned to be spaced apart from the gate structure interposing the first source/drain pattern.

The base insulation layer 100 may include, for example, a layer of oxide, nitride, nitride oxide, or a combination thereof. The base insulation layer 100 may include an insulating material. The base insulation layer 100 may include an insulating material different from the interlayer insulation layer 170. For example, the base insulation layer 100 may include silicon nitride (SiN). Although it is illustrated that the base insulation layer 100 is a single layer, this is merely for the convenience of explanation, and it is not limited thereto. First surface and the second surface of the base insulation layer 100 may be formed as a plane parallel to the second direction D2 crossing the first direction D1 and the first direction D1. For example, the first surface of the base insulation layer 100 may be an upper surface, and the second surface may be a bottom surface. The upper surface of the base insulation layer 100 is a surface opposite to the bottom surface of the base insulation layer 100 in the third direction D3. The third direction D3 may be a direction perpendicular to the first direction D1 and the second direction D2. The bottom surface of the base insulation layer 100 may be referred to as the backside of the base insulation layer 100. In some embodiments, a logic circuit in a cell region may be implemented on the upper surface of the base insulation layer 100. The base insulation layer 100 may include the device isolation trench STI.

The channel layer CH may be disposed on the base insulation layer 100. In an embodiment, the plurality of channel layers 110a, 110b, 110c, and 110d may be disposed on the base insulation layer 100. For example, each of the plurality of channel layers 110a, 110b, 110c, and 110d may be a semiconductor layer of a sheet shape. Each semiconductor layer may be a nanosheet having a thickness of several nanometers along the third direction D3.

In an embodiment, the plurality of channel layers 110a, 110b, 110c, and 110d may be disposed on the base insulation layer 100. The channel layer CH may provide a passage through which current flows between two source/drain patterns 150. Referring to FIG. 2 and FIG. 3, the channel layers 110a, 110b, 110c, and 110d may be disposed between or adjacent to the source/drain patterns 150, and connect the source/drain patterns 150. The channel layers 110a, 110b, 110c, and 110d may penetrate a portion of the gate structure GS in a direction (e.g., the first direction D1) crossing the direction along which the gate structure GS extends. The channel layers 110a, 110b, 110c, and 110d may be arranged to be spaced apart from the upper surface of the base insulation layer 100 in a vertical direction (e.g., the third direction D3). In FIG. 2 and FIG. 3, it is illustrated that four channel layers 110a, 110b, 110c, and 110d are disposed to be spaced apart, but it is not limited thereto, and the number of stacked channel layers CH may be changed in various ways. The channel layers CH may include a semiconductor material. For example, the channel layers CH may include a group IV semiconductor such as Si and Ge, a group III-V compound semiconductor, a group II-VI compound semiconductor, or the like. In an embodiment, the lower pattern BP may be further disposed below the channel layer CH. Specifically, the lower pattern BP may be positioned between the base insulation layer 100 and the sub-gate structure S_GS positioned lowermost among a plurality of sub-gate structures S_GS. The upper surface of the lower pattern BP may contact the lower surface of the sub-gate structure S_GS positioned lowermost among the plurality of sub-gate structures S_GS. The lower pattern BP may include the same material as the channel layer CH. For example, the lower pattern BP may include a group IV semiconductor such as Si and Ge, a group III-V compound semiconductor, a group II-VI compound semiconductor, or the like. However, it is not limited thereto, and the lower pattern BP may include a material different from the channel layer CH.

As another embodiment, unlike what is shown in FIG. 21 and FIG. 22, a semiconductor device may not include the lower pattern BP. In this case, the lower surface of the sub-gate structure S_GS positioned lowermost among the sub-gate structures S_GS may directly contact the base insulation layer 100.

As another embodiment, unlike what is shown in FIG. 21 and FIG. 22, a partial region of the base insulation layer 100 overlapping the sub-gate structure S_GS in the third direction D3 may extend into the interior of the lower pattern BP, and directly contact the lower surface of the sub-gate structure S_GS positioned lowermost among the sub-gate structures S_GS.

A semiconductor device according to an embodiment may further include the field insulation layer 105. The field insulation layer 105 may be positioned on the lower pattern BP. The field insulation layer 105 may be positioned on a sidewall of the lower pattern BP. The field insulation layer 105 may not be positioned on the upper surface of the lower pattern BP. The field insulation layer 105 may cover a portion of a sidewall of the lower pattern BP. In such a case, a portion of the lower pattern BP may protrude from the upper surface of the field insulation layer 105 in the third direction D3. Unlike what is shown, the field insulation layer 105 may entirely cover the side surface of the lower pattern BP. The field insulation layer 105 may include, for example, a layer of oxide, nitride, nitride oxide, or a combination thereof. Although it is illustrated that the field insulation layer 105 is a single layer, this is merely for the convenience of explanation, and it is not limited thereto.

The source/drain pattern 150 may be positioned on the base insulation layer 100. The source/drain pattern 150 may be the positioned at both sides of the channel layer CH or the sub-gate structure S_GS. Specifically, the two source/drain patterns 150 may be arranged in a direction (e.g., the first direction D1) crossing the direction along which the gate structure GS extends, interposing the channel layer CH or the sub-gate structure S_GS. The source/drain pattern 150 may directly contact the channel layer CH or the sub-gate structure S_GS. The source/drain pattern 150 may directly contact the sub-interface insulation layer 133S of the sub-gate structure S_GS. Although not shown in the drawings, an inner spacer may be further disposed between the source/drain pattern 150 and the sub-interface insulation layer 133S. The inner spacer may include at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof.

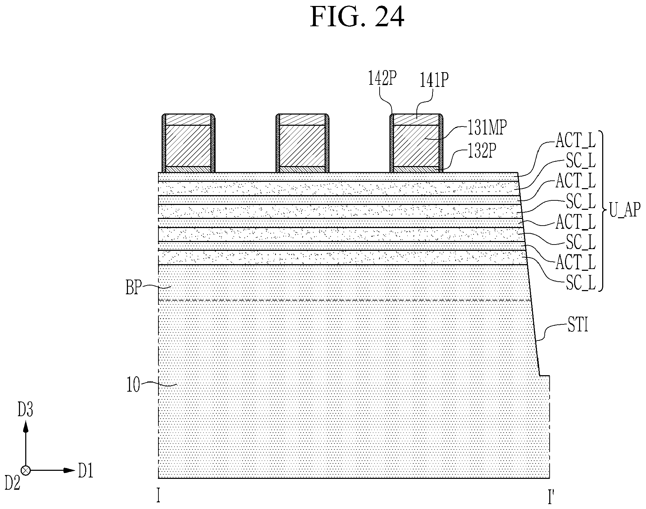

The source/drain pattern 150 may be formed as an epitaxial layer formed by selective epitaxial growth (SEG), in a region where a portion of ACT_L (refer to FIG. 24) and the sacrificial layer SC_L (refer to FIG. 24) pattern the active to be described later is recessed. That is, the source/drain pattern 150 may fill the region where a portion of the sacrificial layer SC_L (refer to FIG. 24) and the active pattern ACT_L (refer to FIG. 24) to be described later is recessed.

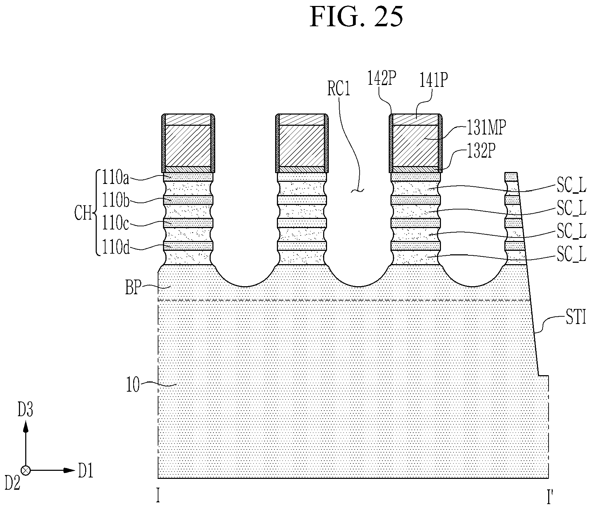

The source/drain pattern 150 may include the first source/drain pattern 151, the second source/drain pattern 152, and the third source/drain pattern 153. The first to third source/drain patterns 151, 152, and 153 may include the liner layers 151a, 152a, and 153a and the filling layers 151b, 152b, and 153b. The liner layers 151a, 152a, and 153a may be positioned on a side surface and the bottom surface of the source/drain pattern 150. The liner layers 151a, 152a, and 153a may directly contact the sub-gate structure S_GS and the channel layer CH. That is, the liner layers 151a, 152a, and 153a may be positioned along the surface profile of the source/drain recess RC1 (refer to FIG. 25) to be described later. The filling layers 151b, 152b, and 153b may be positioned on the liner layers 151a, 152a, and 153a. The filling layers 151b, 152b, and 153b and the liner layers 151a, 152a, and 153a may have upper surfaces of substantially the same height. That is, the filling layers 151b, 152b, and 153b may fill an interior of the source/drain recess RC1 (refer to FIG. 25) to be described later.

The source/drain pattern 150 may include a semiconductor material. The source/drain pattern 150 may include, for example, silicon or germanium. In addition, the source/drain pattern 150 may include, for example, a binary compound, or a ternary compound including at least two or more of carbon (C), silicon (Si), germanium (Ge), tin (Sn). For example, the source/drain pattern 150 may include silicon, silicon-germanium, germanium, silicon carbide, or the like, but is not limited thereto. In an embodiment, the liner layers 151a and 152a and the filling layers 151b and 152b may have different silicon (Si), or germanium (Ge) concentration. For example, the concentration of silicon (Si) or germanium (Ge) included in the liner layers 151a and 152a may be smaller than the concentration of silicon (Si) or germanium (Ge) included in the filling layer 151b, and 152b.

In the case of the semiconductor device disclosed in FIG. 20 to FIG. 23, unlike the semiconductor device described with reference to FIG. 1 to FIG. 4, a source drain pattern 150 may not directly contact the upper conductive pattern 190a or the lower conductive pattern 190b to be described later. A barrier layer 230 to be described later may be positioned between a sidewall of the upper conductive pattern 190a and the first source/drain pattern 151. The barrier layer 230 may include an insulating material. Accordingly, the first source/drain pattern 151 and the upper conductive pattern 190a may be electrically separated by the barrier layer 230. The first source/drain pattern 151 may be connected to the lower wire structure 220 through a first contact electrode 181, the upper conductive pattern 190a and the lower conductive pattern 190b. Unlike the semiconductor device disclosed in FIG. 1 to FIG. 4, the first source/drain pattern 151 may not directly contact the lower conductive pattern 190b and the upper conductive pattern 190a. An upper surface of the first source/drain pattern 151 may contact a first end of the first contact electrode 181. The first source/drain pattern 151 may receive electrical power from the lower wire structure 220 through the lower conductive pattern 190b, the upper conductive pattern 190a and the first contact electrode 181.

In an embodiment, the second source/drain pattern 152 may be connected to the upper wire structure 210 to be described later. The second source/drain pattern 152 may be connected to the upper wire structure 210 through a second contact electrode 182. A portion of the upper surface of the second source/drain pattern 152 may be connected to a portion of the second contact electrode 182. In an embodiment, the current having passed through the channel layer CH may be transferred to the upper wire structure 210 through the second source/drain pattern 152 and the second contact electrode 182. Referring to FIG. 21, although the filling layer 152b of the second source/drain pattern 152 is illustrated to be connected to the second contact electrode 182, the second contact electrode 182 may also be connected to the liner layer 152a of the second source/drain pattern 152.

The gate structure GS may be disposed on the base insulation layer 100. The gate structure GS may include the sub-gate structure S_GS and the main gate structure M_GS. The sub-gate structure S_GS may be disposed on the base insulation layer 100, and the main gate structure M_GS may be disposed on the sub-gate structure S_GS. On the base insulation layer 100, the gate structure GS may extend in a different direction other than the direction along which the source/drain patterns 150 are arranged. For example, on the base insulation layer 100, the gate structure GS may extend in a direction (e.g., the second direction D2) crossing the direction along which the source/drain patterns 150 are arranged. The gate structure GS may be positioned on the base insulation layer 100. The gate structures GS may be arranged to be spaced apart in the first direction D1. The main gate structure M_GS may be positioned on the channel layer 110a positioned uppermost. The main gate structure M_GS may also be positioned on a side surface of the structure in which the channel layers 110a, 110b, 110c, and 110d and the sub-gate structures S_GS are stacked. That is, the main gate structure M_GS may surround each of the channel layers 110a, 110b, 110c, and 110d together with the sub-gate structures S_GS. However, the main gate structure M_GS may not be positioned on a surface where each channel layers 110a, 110b, 110c, and 110d contacts the source/drain pattern 150. In FIG. 2 and FIG. 3, it is illustrated that four the sub-gate structures S_GS are arranged in the third direction, but the number of the arranged sub-gate structures S_GS is not limited thereto. For example, the gate structure GS may include three the sub-gate structures S_GS.

The sub-gate structures S_GS may contact the source/drain pattern 150. For example, the sub-gate structure S_GS may directly contact the source/drain pattern 150. The sub-gate structures S_GS may be positioned at both sides of the source/drain pattern 150. The sub-gate structures S_GS each may be formed in multiple layers. For example, the sub-gate structures S_GS each may include the sub-gate electrode 131S, the sub-gate insulation layer 132S and the sub-interface insulation layer 133S. The sub-gate structures S_GS and the channel layers 110a, 110b, 110c, and 110d may be alternately stacked in the third direction D3. The sub-gate structures S_GS may surround surfaces of the channel layers 110a, 110b, 110c, and 110d other than surfaces connected to the source/drain pattern 150, together with the main gate structure M_GS.

The sub-gate electrode 131S may include at least one of a metal, a metal alloy, a conductive metal nitride, a metal silicide, a doped semiconductor material, a conductive metal oxide, and a conductive metal nitride oxide. The sub-gate electrode 131S may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn), vanadium (V), and a combination thereof, but is not limited thereto. The conductive metal oxide and the conductive metal nitride oxide may include oxidized forms of the above-mentioned materials, but is not limited thereto.

The sub-interface insulation layer 133S may be positioned along the circumference of the channel layer CH. For example, the sub-interface insulation layer 133S may surround surfaces of the channel layer CH other than the surface connected to the source/drain pattern 150. The sub-interface insulation layer 133S may directly contact the source/drain pattern 150 and the channel layer CH. The sub-interface insulation layer 133S may be interposed between the channel layer CH and the sub-gate insulation layer 132S. The sub-interface insulation layer 133S may include, for example, silicon oxide (SiO₂).

The sub-gate insulation layer 132S may extend along the upper surface of the sub-interface insulation layer 133S. The sub-gate insulation layer 132S may surround the channel layer CH. For example, the sub-gate insulation layer 132S may surround surfaces of the channel layer CH other than the surface connected to the source/drain pattern 150. The sub-gate insulation layer 132S may be positioned along the circumference of the channel layer CH. The sub-gate insulation layer 132S may be interposed between the sub-gate electrode 131S and the sub-interface insulation layer 133S. The sub-gate insulation layer 132S may include, for example, high dielectric constant material. High dielectric constant material may include a material having a higher dielectric constant than silicon oxide (SiO₂) such as hafnium oxide (HfO), aluminum oxide (AlO), or tantalum oxide (TaO).

The main gate structure M_GS may be positioned on the sub-gate structure S_GS and the channel layer CH. The main gate structure M_GS may be positioned on the upper surface of the channel layer CH. The main gate structures M_GS each may be formed in multiple layers. For example, the main gate structure M_GS may include the main gate electrode 131M, the main interface insulation layer 133M, the main gate insulation layer 132M. The main gate structure M_GS may surround surfaces of at least one (e.g., 110a)of the channel layers CH other than the surface connected to the source/drain pattern 150, together with the sub-gate structure S_GS.

The main gate electrode 131M may be positioned on the sub-gate structure S_GS and the channel layer CH. The main gate electrode 131M may be positioned on the upper surface of the channel layer CH. The main gate electrode 131M may include the same material as the sub-gate electrode 131S. For example, the main gate electrode 131M may include at least one of a metal, a metal alloy, a conductive metal nitride, a metal silicide, a doped semiconductor material, a conductive metal oxide, and a conductive metal nitride oxide.

The main interface insulation layer 133M may extend along the upper surface of the channel layer CH. The main interface insulation layer 133M may include, for example, silicon oxide (SiO₂). The main gate insulation layer 132M may extend along the side surface and the bottom surface of the main gate electrode 131M. The main gate insulation layer 132M may include, for example, high dielectric constant material.

A semiconductor device according to an embodiment may further include the capping layer 141 and the gate spacer 142. The gate spacer 142 may be positioned on the side surface of the main gate electrode 131M. The gate spacer 142 may not be disposed between the lower pattern BP and the channel layer CH. The gate spacer 142 may not be disposed between the channel layers CH adjacent in the third direction D3. Although the gate spacer 142 is illustrated as a single layer, this is merely for the convenience of explanation, and it is not limited thereto. The gate spacer 142 may include, for example, at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof.

The capping layer 141 may be positioned on the main gate structure M_GS and the gate spacer 142. Unlike what is shown, the capping layer 141 may be positioned between the gate spacers 142. The capping layer 141 may include, for example, at least one of silicon nitride (SiN), silicon nitride oxide (SiON), silicon (Si) carbonitride (SiCN), silicon carbonate nitride (SiOCN) and a combination thereof. The capping layer 141 may include a material having etch selectivity with respect to the interlayer insulation layer 170 to described later.

The through electrode 190 may be positioned to be spaced apart from the gate structure GS, interposing the first source/drain pattern 151. The through electrode 190 may penetrate the base insulation layer 100, and electrically connect the lower wire structure 220 described later and the first source/drain pattern 151. In an embodiment, the through electrode 190 may include the upper conductive pattern 190a and the lower conductive pattern 190b.

The upper conductive pattern 190a may be positioned between the two source/drain patterns 150. The upper conductive pattern 190a may be positioned between the source/drain patterns 150 of two different semiconductor devices. For example, referring to FIG. 21, the upper conductive pattern 190a may be positioned between the first source/drain pattern 151 and the third source/drain pattern 153. The first source/drain pattern 151 and the third source/drain pattern 153 may be the source/drain pattern 150 of each of adjacent two different semiconductor devices. The upper conductive pattern 190a may extend in the third direction D3. The upper conductive pattern 190a may have an upper surface at substantially the same height as an upper surface of the main gate structure M_GS and the dummy gate spacer 160b described later. The upper surface of the upper conductive pattern 190a may contact a lower surface of the dummy capping layer 160a described later. A portion of the upper surface of the upper conductive pattern 190a may also contact a lower surface of a first contact electrode 180. Specifically, a portion of the upper surface of the upper conductive pattern 190a may contact a lower surface of a first via 181a penetrating a portion of the dummy capping layer 160a in the third direction D3. The lower surface of the upper conductive pattern 190a may contact the upper surface of the lower conductive pattern 190b. The interface between the upper conductive pattern 190a and the lower conductive pattern 190b may be positioned lower than the bottom surface of the source/drain pattern 150. The interface between the upper conductive pattern 190a and the lower conductive pattern 190b may be positioned upper than the interface between the lower pattern BP and the base insulation layer 100. That is, the interface between the upper conductive pattern 190a and the lower conductive pattern 190b may be positioned between the interface between the lower pattern BP and the base insulation layer 100 and the bottom surface of the source/drain pattern 150. However, but is not limited thereto, the interface between the upper conductive pattern 190a and the lower conductive pattern 190b may be positioned lower than the interface between the lower pattern BP and the base insulation layer 100. However, even in this case, the interface between the upper conductive pattern 190a and the lower conductive pattern 190b may be positioned lower than the bottom surface of the source/drain pattern 150.

In an embodiment, the width of the upper conductive pattern 190a in the first direction D1 may be smaller than or equal to the width of the lower conductive pattern 190b in the first direction D1. The width of the upper conductive pattern 190a in the first direction D1 may be substantially the same as the width of the adjacent sub-gate structure S_GS in the first direction D1.

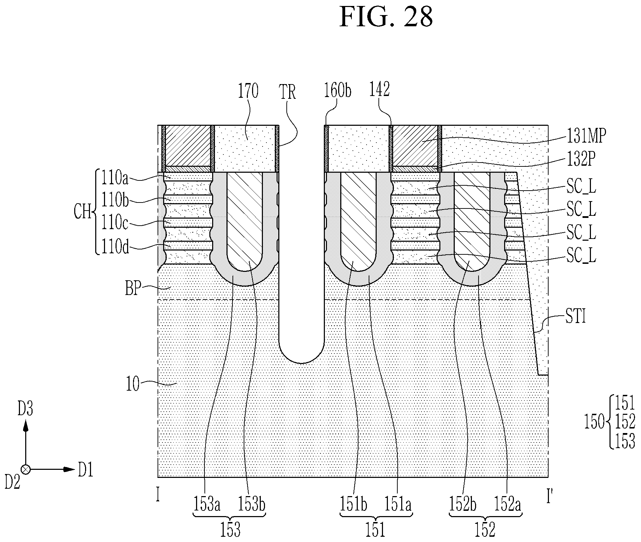

In an embodiment, the width of the upper conductive pattern 190a in the first direction D1 may be the same as the width of the channel layer CH in the first direction D1. However, it is not limited thereto, and the width of the upper conductive pattern 190a in the first direction D1 may be smaller than the width of the channel layer CH in the first direction D1. When the width of the upper conductive pattern 190a in the first direction D1 is smaller than the width of the channel layer CH in the first direction D1, a residual semiconductor material may be positioned between the upper conductive pattern 190a and the source/drain pattern 150. When the channel layer CH and the sacrificial layer SC_L are removed in the process (refer to FIG. 28) of forming the upper conductive pattern 190a described later, the residual semiconductor material may be a partial region of the channel layer CH that is not removed but remains between the source/drain pattern and a sidewall of the trench TR. The residual semiconductor material may include the same material as the channel layer CH. For example, the residual semiconductor material may include Si, or SiGe. The upper conductive pattern 190a may include a metal or metal alloy. The upper conductive pattern 190a may include, for example, at least one of titanium (Ti), tantalum (Ta), nickel (Ni), cobalt (Co) tungsten (W), molybdenum (Mo), ruthenium (Ru) and platinum (Pt). In an embodiment, the upper conductive pattern 190a may include the same material as the lower conductive pattern 190b. The upper conductive pattern 190a may be integrally formed in the same process as the lower conductive pattern 190b.

The lower conductive pattern 190b may be positioned between the lower wire structure 220 and the upper conductive pattern 190a. The lower conductive pattern 190b may penetrate the base insulation layer 100 and extend in the third direction D3. The first end of the lower conductive pattern 190b may be connected to the lower surface of the upper conductive pattern 190a, and a second end thereof may be connected to the lower wire structure 220. In the case of the semiconductor device disclosed in FIG. 20 to FIG. 23, unlike the semiconductor device disclosed in FIG. 1 to FIG. 4, the lower conductive pattern 190b may not contact the source/drain pattern 150.

The upper surface of the lower conductive pattern 190b may contact the lower surface of the upper conductive pattern 190a. In an embodiment, the width of the lower conductive pattern 190b in the first direction D1 may be greater than or equal to the width of the upper conductive pattern 190a in the first direction D1. The width of the lower conductive pattern 190b in the first direction D1 may be greater than or equal to the width of the adjacent sub-gate structure S_GS in the first direction D1. The width of the lower conductive pattern 190b in the first direction D1 may be greater than or equal to a width of the channel layer CH in the second direction.

The lower conductive pattern 190b may include a metal or metal alloy. The lower conductive pattern 190b may include, for example, at least one of titanium (Ti), tantalum (Ta), nickel (Ni), cobalt (Co) tungsten (W), molybdenum (Mo), ruthenium (Ru) and platinum (Pt). In an embodiment, the lower conductive pattern 190b may include the same material as the upper conductive pattern 190a. The lower conductive pattern 190b may be integrally formed in the same process as the upper conductive pattern 190a.

A semiconductor device according to an embodiment may further include the barrier layer 230. The barrier layer 230 may extend along the profile of both side surfaces of the upper conductive pattern 190a and the lower conductive pattern 190b. The barrier layer 230 may extend to a bottom surface of the dummy capping layer 160a. That is, an upper surface of the barrier layer 230 may contact the bottom surface of the dummy capping layer 160a. The barrier layer 230 may be positioned between the dummy gate spacer 160b and the upper conductive pattern 190a. A portion of the upper surface of the barrier layer 230 may contact the first contact electrode 181. Specifically, a portion of the upper surface of the barrier layer 230 may contact a lower surface of the first via 181a that penetrates the dummy capping layer 160a and contacts the lower surface of the upper conductive pattern 190a. A lower surface of the barrier layer 230 may contact the lower wire structure 220. The barrier layer 230 may also be positioned between the first and third source drain patterns 151 and 153 and the upper conductive pattern 190a. The barrier layer 230 may also be positioned between the lower conductive pattern 190b and the base insulation layer 100.

The barrier layer 230 may include an insulating material. For example, the barrier layer 230 may include silicon oxide or silicon nitride. The barrier layer 230 may electrically separate the upper conductive pattern 190a and the source/drain pattern 150. The barrier layer 230 may electrically separate the lower conductive pattern 190b and the source/drain pattern 150.

A semiconductor device according to an embodiment may further include the dummy capping layer 160a and the dummy gate spacer 160b. The dummy capping layer 160a may be positioned on the upper conductive pattern 190a and the dummy gate spacer 160b. The dummy capping layer 160a may cover the upper surfaces of the upper conductive pattern 190a and the dummy gate spacer 160b. The dummy capping layer 160a may be positioned in substantially the same layer as the capping layer 141. The dummy capping layer 160a may have an upper surface at substantially the same height as the upper surface of the capping layer 141. The dummy capping layer 160a may have a lower surface at substantially the same height as the lower surface of the capping layer 141. The dummy capping layer 160a may include the same material as the capping layer 141. The dummy capping layer 160a may include, for example, at least one of silicon nitride (SiN), silicon nitride oxide (SiON), silicon (Si) carbonitride (SiCN), silicon carbonate nitride (SiOCN) and a combination thereof. The dummy capping layer 160a may include a material having etch selectivity with respect to the interlayer insulation layer 170. The dummy capping layer 160a may be simultaneously formed with the capping layer 141, in the same process as the capping layer 141.

The dummy gate spacer 160b may be positioned on the side surface of the upper conductive pattern 190a. Specifically, the dummy gate spacer 160b may be positioned between the interlayer insulation layer 170 and the upper conductive pattern 190a. The dummy gate spacer 160b may not be positioned on the interface between the upper conductive pattern 190a and the first source/drain pattern 151. That is, in a region adjacent to the source/drain pattern 150, the dummy gate spacer 160b may have a lower surface at substantially the same height as the upper surface of the source/drain pattern 150. The dummy gate spacer 160b may have an upper surface at substantially the same height as the upper surface of the main gate structure M_GS. The dummy gate spacer 160b may be positioned in substantially the same layer as the gate spacer 142. The dummy gate spacer 160b may have an upper surface at substantially the same height as the upper surface of the gate spacer 142. The dummy gate spacer 160b may have a lower surface at substantially the same height as the lower surface of the gate spacer 142. The dummy gate spacer 160b may include the same material as the gate spacer 142. For example, the dummy gate spacer 160b may include at least one of silicon nitride (SiN), silicon nitride oxide (SiON), silicon oxide (SiO₂), silicon carbonate nitride (SiOCN), silicon boronnitride (SiBN), silicon oxyboronitride (SiOBN), silicon oxycarbide (SiOC), and a combination thereof. The dummy gate spacer 160b may be simultaneously formed with the gate spacer 142, in the same process as the gate spacer 142.

The lower wire structure 220 may be disposed on the bottom surface of the base insulation layer 100. In an embodiment, the lower wire structure 220 may be a component for supplying electrical power to at least one of the source/drain patterns 150. For example, the lower wire structure 220 may be a power delivery network. The lower wire structure 220 may include the lower wires 221, the lower vias 222 and the lower insulation layer 223. The lower wires 221 and the lower vias 222 may be positioned on the bottom surface of the base insulation layer 100. The lower wires 221 and the lower vias 222 may include a metal (e.g., copper). The lower insulation layer 223 may be positioned on the bottom surface of the base insulation layer 100. The lower insulation layer 223 may be disposed between the bottom surface of the base insulation layer 100, the lower wires 221 and the lower vias 222 and insulate them. That is, the lower insulation layer 223 may cover the lower wires 221 and the bottom surface of the base insulation layer 100. The lower wire 221 and the lower vias 222 may be positioned within the lower insulation layer 223. The lower insulation layer 223 may include, for example, at least one of silicon oxide (SiO₂), silicon nitride (SiN), silicon nitride oxide (SiON), or low dielectric layers.

In an embodiment, a semiconductor device may further include the interlayer insulation layer 170, the upper wire structure 210 and the contact electrode 180. The contact electrode 180 may include the first contact electrode 181 and the second contact electrode 182.

The interlayer insulation layer 170 may cover the channel layer CH, the gate structure GS, the source/drain pattern 150, and the through electrode 190. The interlayer insulation layer 170 may include, for example, at least one of silicon oxide (SiO₂), silicon nitride (SiN), silicon nitride oxide (SiON), and a low dielectric constant material. Low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), fluoride silicate glass (FSG), polyimide nanofoams such as polypropylene oxide, carbon-doped silicon oxide (CDO), organo-silicate glass (OSG), SiLK, Amorphous Fluorinated Carbon, silica aerogels, silica xerogels, mesoporous silica or a combination thereof, but is not limited thereto. In an embodiment, the interlayer insulation layer 170 may include a different material from the base insulation layer 100.

The upper wire structure 210 may be positioned on the interlayer insulation layer 170. The upper wire structure 210 may include the upper wires 211, the upper vias 212 and the upper insulation layer 213. The upper wires 211 and the upper vias 212 may include a metal (e.g., copper). The upper insulation layer 213 may be disposed between the upper wires 211 and the upper vias 212 and insulate them. The upper insulation layer 213 may cover the interlayer insulation layer 170 and the upper wires 211. The upper wires 211 and the upper vias 212 may be positioned within the upper insulation layer 213. The upper insulation layer 213 may include, for example, at least one of silicon oxide (SiO₂), silicon nitride (SiN), silicon nitride oxide (SiON), or low dielectric layers.

The contact electrode 180 may be a configuration for connecting the source/drain pattern 150 to the upper wire structure 210 or the lower wire structure 220. In an embodiment, the first contact electrode 181 may be disposed between the first source/drain pattern 151 and the through electrode 190. In an embodiment, the first contact electrode 181 may electrically connect the first source/drain pattern 151 and the upper conductive pattern 190a. The first source/drain pattern 151 may be connected to the lower wire structure 220 through the first contact electrode 181, the upper conductive pattern 190a and the lower conductive pattern 190b.

The first contact electrode 181 may include the first via 181a and a second via 181b. The first via 181a may be disposed between first source/drain pattern 151 and the second via 181b, and thereby may connect the first source/drain pattern 151 and the second via 181b. The first via 181a may have an upper surface at substantially the same height as an upper surface of a third via 182a to be described later. In an embodiment, the first via 181a may be simultaneously formed in the same process as the third via 182a.

The second via 181b may be disposed between the first via 181a and the upper conductive pattern 190a, and connect the first via 181a and the upper conductive pattern 190a. In an embodiment, the second via 181b may have an upper surface at substantially the same height as an upper surface of a fourth via 182b to be described later. In this case, the second via 181b may be simultaneously formed in the same process as the fourth via 182b. However, but is not limited thereto, the second via 181b may be simultaneously formed in the same process as an electrode (not shown) for connecting the main gate electrode 131M and the upper wire structure 210. Referring to FIG. 21, it is illustrated that an upper surface of the second via 181b contacts the upper insulation layer 213 included in the upper wire structure 210, but the height of the upper surface of the second via 181b is not limited to the present embodiment. For example, the second via 181b may have an upper surface at substantially the same height as the first via 181a, or may have an upper surface between a bottom surface of the upper wire structure 210 and an upper surface of the first via 181a. Even if the upper surface of the second via 181b is in contact with the upper insulation layer 213, the upper surface of the second via 181b may not contact the upper wires 211 or the upper vias 212. The second via 181b may penetrate the dummy capping layer 160a, and extend to the upper surface of the upper conductive pattern 190a in the third direction D3. Accordingly, a portion of lower surface of the second via 181b may contact the upper surface of the upper conductive pattern 190a.

In an embodiment, the second contact electrode 182 may be disposed between the second source/drain pattern 152 and the upper wire structure 210, and connect the second source/drain pattern 152 and the upper wire structure 210. The second contact electrode 182 may include the third via 182a and the fourth via 182b. The second contact electrode 182 may penetrate the interlayer insulation layer 170 in the third direction D3. The third via 182a may contact the upper surface of the second source/drain pattern 152. The third via 182a may extend in the third direction D3. The third via 182a may have an upper surface at a height the same as or higher than the upper surface of the capping layer 141. The fourth via 182b may be positioned on the third via 182a. A first end of the fourth via 182b may directly contact the third via 182a in the third direction D3. A second end of the fourth via 182b may directly contact the upper wire structure 210. The third via 182a and the fourth via 182b may include at least one of a metal, a metal alloy, a conductive metal nitride, a conductive metal carbide, a conductive metal oxide, a conductive metal carbonitride, and a 2-dimensional material. The metal may include, titanium (Ti), at least one of tantalum (Ta), tungsten (W), nickel (Ni), cobalt (Co) and platinum (Pt). The conductive metal nitride may include at least one of titanium nitride (TiN), tantalum nitride (TaN), tungsten nitride (WN), nickel nitride (NiN), cobalt nitride (CoN) and platinum nitride (PtN).

FIG. 24 to FIG. 40 are drawings for explaining a method of manufacturing a semiconductor device according to an embodiment.

As shown in FIG. 24, the lower pattern BP and the upper pattern structure U_AP may be formed on the substrate 10. The substrate 10 may be silicon-on-insulator (SOI) or bulk silicon. Alternatively, the substrate 10 may be silicon substrate, and may include other materials, for example, silicon germanium (SiGe), Silicon-Germanium on Insulator (SGOI), indium antimonide, lead tellurium compound, indium arsenic, indium phosphide, gallium arsenide or gallium antimonide, but is not limited thereto. The lower pattern BP may be a portion of the substrate 10.

The upper pattern structure U_AP may be positioned on the lower pattern BP. The upper pattern structure U_AP may include the sacrificial layer SC_L and the active pattern ACT_L alternately stacked on the lower pattern BP. For example, the sacrificial layer SC_L may include silicon germanium (SiGe). The active pattern ACT_L may include silicon (Si).

Subsequently, on the upper pattern structure U_AP, the preliminary gate insulation layer 132P, the preliminary main gate electrode 131 MP and the preliminary capping layer 141P are formed. The preliminary gate insulation layer 132P may include, for example, silicon oxide (SiO₂), but is not limited thereto. The preliminary main gate electrode 131MP may include, for example, polysilicon, but is not limited thereto. The preliminary capping layer 141P may include, for example, silicon nitride, but is not limited thereto. On the both side surfaces of the preliminary main gate electrode 131MP, the preliminary gate spacer 142P may be formed.

As shown in FIG. 25, by using the preliminary capping layer 141P and the preliminary gate spacer 142P as a mask, the source/drain recess RC1 is formed by etching at least a portion of the upper pattern structure U_AP. As the source/drain recess RC1 is formed, at least a portion of the lower pattern BP may be etched. A portion of the source/drain recess RC1 may be formed within the substrate 10. Meanwhile, as shown in FIG. 6, after forming the source/drain recess RC1, indent process with respect to the sacrificial layer SC_L may be performed. In the indent process, the sacrificial layer SC_L is etched by the wet etching or dry etching method, and accordingly, the length of the sacrificial layer SC_L in the first direction D1 may be further reduced. Accordingly, the surface of the sacrificial layer SC_L contacting the source/drain recess RC1 may have a concave shape toward the source/drain recess RC1.

As the source/drain recess RC1 is formed, the active pattern ACT_L are separated such that the channel layers 110a, 110b, 110c, and 110d may be formed. The channel layers 110a, 110b, 110c, and 110d may be positioned at both sides of the source/drain recess RC1. The channel layers 110a, 110b, 110c, and 110d and the sacrificial patterns SC_L may be alternately stacked in the third direction D3. At this time, lengths of the channel layers 110a, 110b, 110c, and 110d may be different, and may be the same.

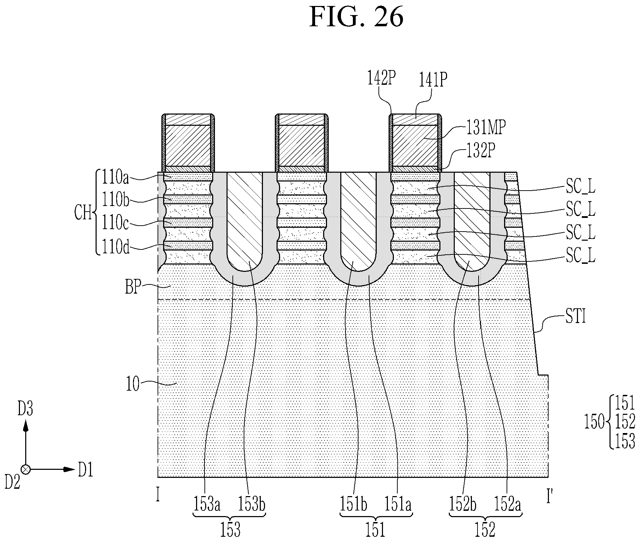

As shown in FIG. 26, the source/drain pattern 150 may be formed within the source/drain recess RC1. The source/drain pattern 150 may be formed on the substrate 10. The source/drain pattern 150 may be formed by using an epitaxial growth method. At this time, the inner wall of the source/drain recess may be used as a seed. The source/drain pattern 150 may directly contact the substrate 10 or the lower pattern BP. The source/drain pattern 150 may directly contact the channel layers 110a, 110b, 110c, and 110d and sacrificial layers SC_L. The source/drain pattern 150 may include silicon (Si), germanium (Ge) or silicon germanium (SiGe). The source/drain pattern 150 may be formed of several regions having different concentrations. For example, referring to FIG. 26, each of source/drain patterns 151, 152, and 153 may include the liner layers 151a, 152a, and 153a and the filling layers 151b, 152b, and 153b. First, the liner layers 151a, 152a, and 153a are formed along the sidewall and bottom surface of the source/drain recess RC1, and the filling layers 151b, 152b, and 153b may be formed on each of the liner layers 151a, 152a, and 153a. The liner layers 151a, 152a, and 153a and the filling layers 151b, 152b, and 153b may be formed by using an epitaxial growth method, respectively. The liner layers 151a, 152a, and 153a and the filling layers 151b, 152b, and 153b may include a semiconductor material. For example, the liner layers 151a, 152a, and 153a and the filling layers 151b, 152b, and 153b may include silicon (Si) or germanium (Ge), which are elemental semiconductor materials. In an embodiment, the liner layers 151a, 152a, and 153a and the filling layers 151b, 152b, and 153b may have different silicon (Si), or germanium (Ge) concentration. For example, the concentration of silicon (Si) or germanium (Ge) included in the liner layers 151a, 152a, and 153a may be smaller than the concentration of silicon (Si) or germanium (Ge) included in the filling layers 151b, 152b, and 153b.

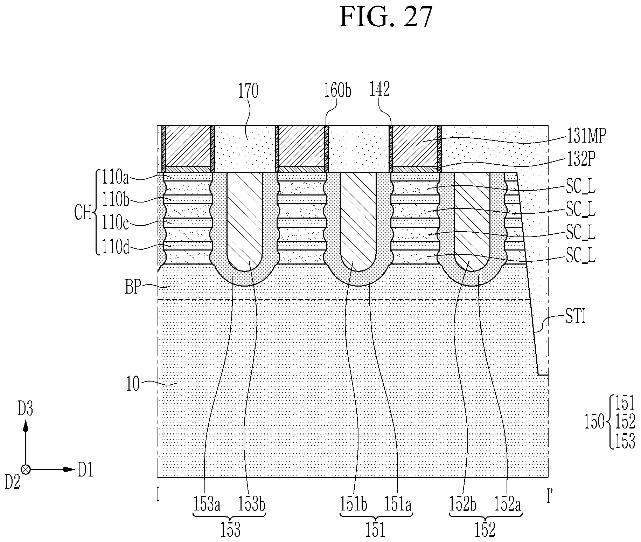

As shown in FIG. 27, the interlayer insulation layer 170 may be formed on the source/drain pattern 150. Subsequently, a portion of the interlayer insulation layer 170 and the preliminary capping layer 141P may be removed, so as to expose the upper surface of the preliminary main gate electrode 131MP. At this time, a portion of the preliminary gate spacer 142P may be removed together, such that the gate spacer 142 and the dummy gate spacer 160b may be formed. The gate spacer 142 and the dummy gate spacer 160b may be simultaneously formed in the same process.

As shown in FIG. 28, the trench TR may be formed by etching a portion of the channel layer CH and a portion of the sacrificial layer SC_L. A portion of the channel layer CH and a portion of the sacrificial layer SC_L that are removed may be a partial region of the channel layer CH and a partial region of the sacrificial layer SC_L positioned between the source/drain patterns 150 of adjacent two semiconductor devices. For example, in FIG. 28, a partial region of the channel layer CH and a partial region of the sacrificial layer SC_L positioned between the first source/drain pattern 151 and the third source/drain pattern 153 may be removed. At this time, the preliminary gate insulation layer 132P and the preliminary main gate electrode 131MP positioned on the channel layer CH and the sacrificial layer SC_L that are removed may also be removed together. However, even in this case, the dummy gate spacer 160b may not be removed. The trench TR may penetrate the channel layer CH and the sacrificial layer SC_L, and extend in the third direction D3. That is, compared to the bottom surface of the source/drain pattern 150, the bottom surface of the trench TR may be positioned closer to the bottom surface of the substrate 10. While a partial region of the channel layer CH, a partial region of the sacrificial layer SC_L, a portion of the preliminary gate insulation layer 132P and a portion of the preliminary main gate electrode 131MP, positioned between the source/drain patterns 150 of adjacent two semiconductor devices, are removed, a remaining region may be covered by a separate mask pattern. In an embodiment, the channel layer CH, the sacrificial layer SC_L, the preliminary gate insulation layer 132P and the preliminary main gate electrode 131MP that are removed may be removed by a dry etching process. However, it is not limited thereto, and all or part of the channel layer CH, the sacrificial layer SC_L, the preliminary gate insulation layer 132P and the preliminary main gate electrode 131MP that are removed may be removed by a wet etching process. Referring to FIG. 28, after forming the trench TR, between the first source/drain pattern 151 and the sidewall of the trench TR and between the third source/drain pattern 153 and the sidewall of the trench TR, a partial region of the channel layer CH may remain by not being removed.

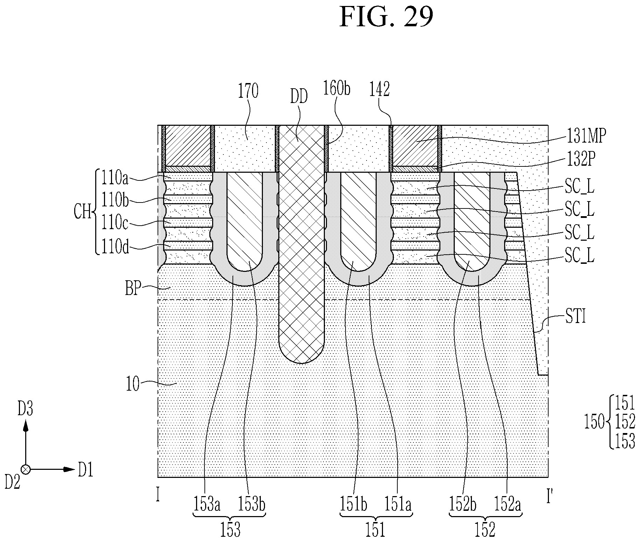

As shown in FIG. 29, the trench TR may be filled with the dummy insulation pattern DD. The dummy insulation pattern DD may include an insulating material. For example, the dummy insulation pattern DD may include silicon oxynitride (SiON) or silicon nitride (SiN). After the dummy insulation pattern DD is filled in the trench TR, the process for planarizing the upper surface of the dummy insulation pattern DD may be additionally performed. For example, the upper surface of the dummy insulation pattern DD may be planarized by a chemical mechanical polishing (CMP) process.

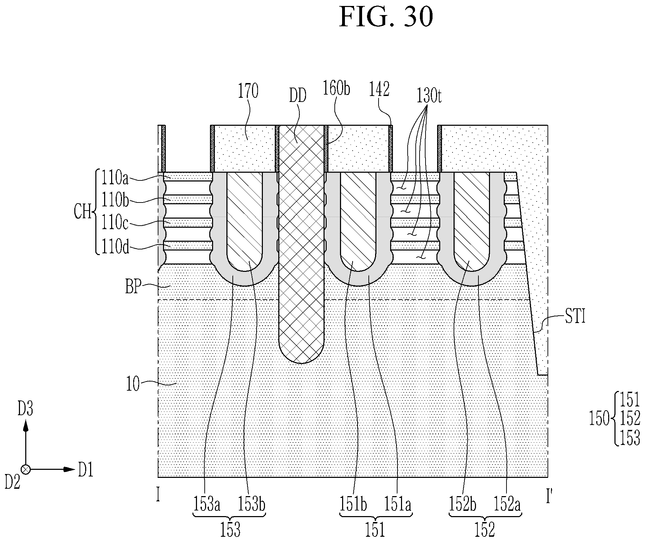

As shown in FIG. 30, after forming the dummy insulation pattern DD, the remaining preliminary gate insulation layers 132P and the preliminary main gate electrode 131MPs may be removed, such that the upper pattern structure U_AP between the gate spacers 142 may be exposed. Subsequently, the sacrificial layer SC_L between the channel layer CH and the lower pattern BP may be removed, and thereby the gate trench 130t may be formed. The sub-interface insulation layer 133S and the main interface insulation layer 133M may be simultaneously formed in the same process. The sub-gate insulation layer 132S and the main gate insulation layer 132M may be simultaneously formed in the same process. The sub-gate electrode 131S and the main gate electrode 131M may be simultaneously formed in the same process.

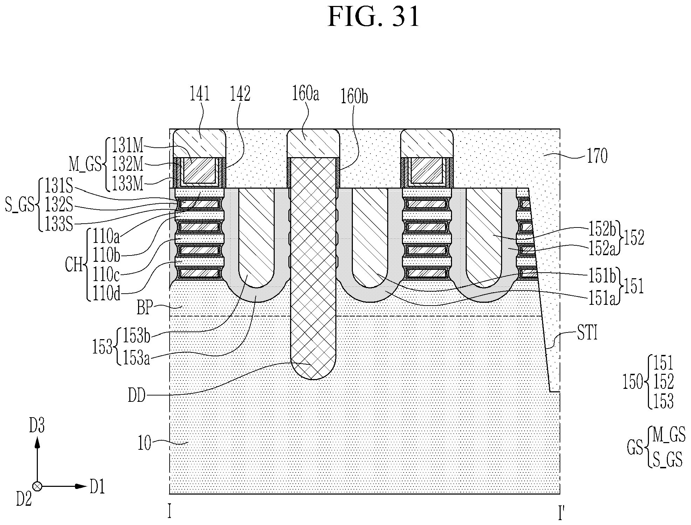

As shown in FIG. 31, the sub-interface insulation layer 133S, the sub-gate insulation layer 132S, the sub-gate electrode 131S may be sequentially formed within the gate trench 130t. In addition, the main interface insulation layer 133M, the main gate insulation layer 132M, the main gate electrode 131M, and the capping layer 141 may be sequentially formed.

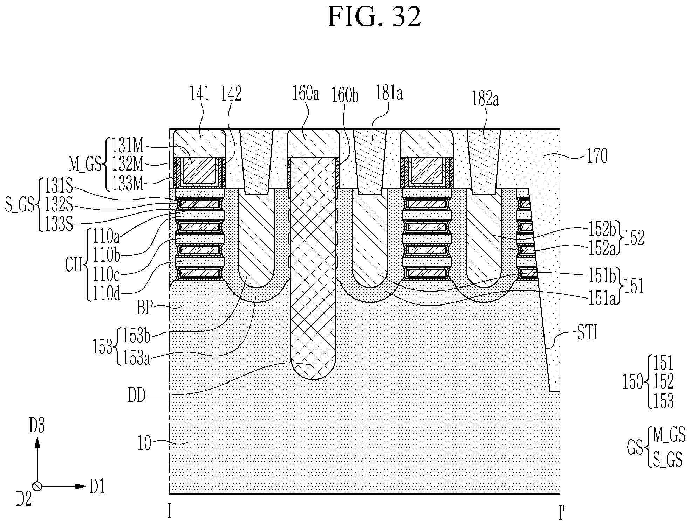

As shown in FIG. 32, a portion of the interlayer insulation layer 170 may be patterned, and thereby the first via 181a and the third via 182a may be formed. The first via 181a may contact the upper surface of the first source/drain pattern 151, and the third via 182a may contact the upper surface of the second source/drain pattern 152. Specifically, after each etching a portion of the interlayer insulation layer 170 overlapping the first source/drain pattern 151 and the second source/drain pattern 152 in the third direction D3, the first via 181a and the third via 182a may be formed, respectively. At this time, by using an etchant having a higher etch selectivity with respect to the interlayer insulation layer 170 compared to the source/drain pattern 150, a portion of the interlayer insulation layer 170 may be etched. Accordingly, the first source/drain pattern 151 and a portion of the upper surface of the second source/drain pattern 152 may be exposed. Another in an embodiment, a portion of the interlayer insulation layer 170 may be etched by a dry etching process. A first end of the first via 181a may directly contact an upper surface of the first source/drain pattern 151, and the second end of the first via 180a may directly contact the second via 180b to be formed later. A first end of the third via 182a may directly contact the upper surface of the second source/drain pattern 152, and a second end of the third via 182a may be connected to the fourth via 182b to be formed later. In an embodiment, the first via 181a and the third via 182a may be simultaneously formed in the same process.

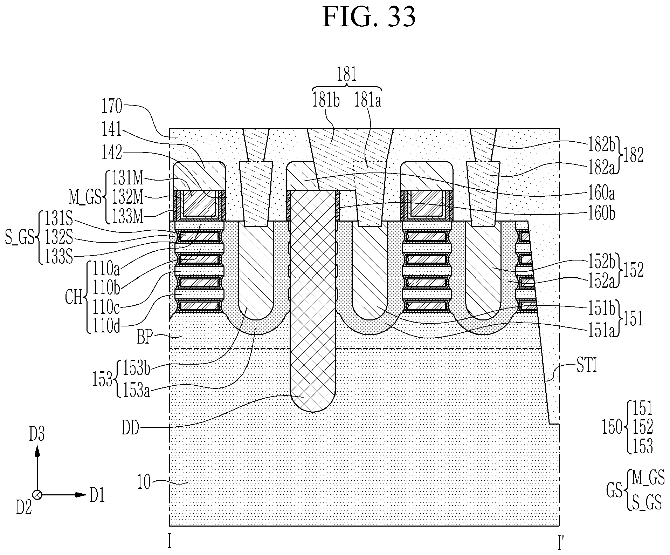

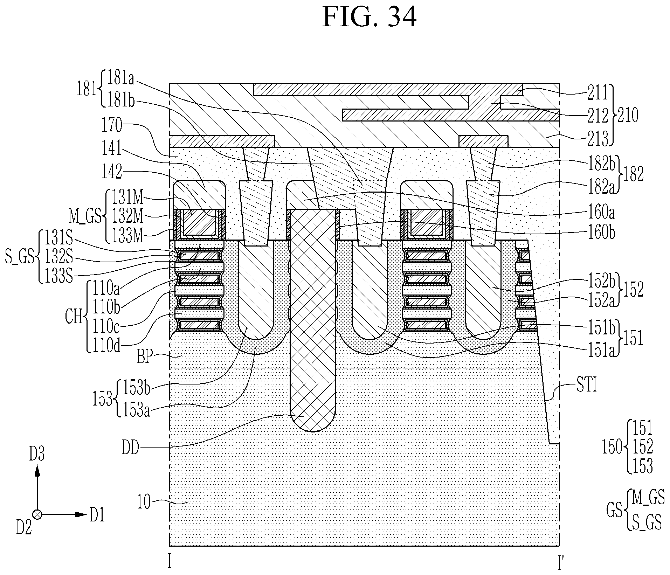

As shown in FIG. 33, the interlayer insulation layer 170 may be additionally formed at a higher level than the upper surface of the capping layer 141. At this time, the additionally formed interlayer insulation layer 170 may include the same insulating material as the interlayer insulation layer 170 that has been already formed on the source/drain pattern 150. Accordingly, between the interlayer insulation layer 170 formed later and the interlayer insulation layer 170 having been already formed, a boundary may not be visible. Thereafter, after etching a portion of the interlayer insulation layer 170 and the dummy capping layer 160a, the second via 181b may be formed. Specifically, by etching the first via 181a and a partial region of the dummy capping layer 160a and a portion of the interlayer insulation layer 170 overlapping them, the upper surface of the first via 181a and a portion of an upper surface of the dummy capping layer 160a may be exposed. Subsequently, a portion of the upper surface of the dummy insulation pattern DD may be exposed by etching a portion of the dummy capping layer 160a. The process of etching the interlayer insulation layer 170 and the dummy capping layer 160a may be simultaneously performed by one process. Thereafter, the second via 181b contacting the upper surface of the first via 181a and the portion of the upper surface of the dummy capping layer 160a may be formed. After etching a portion of the interlayer insulation layer 170 overlapping the third via 182a in the third direction D3, the fourth via 182b may be formed. A first end of a fourth via 18b may be connected to the second end of the first via 180a, and the second end of the fourth via 182b may be connected to the upper wire structure 210 (refer to FIG. 34) to be formed later. The process of forming the second via 181b and the fourth via 182b may be simultaneously performed. However, but is not limited thereto, the second via 181b and the fourth via 182b may be performed in separate processes, respectively.

As shown in FIG. 34, on the interlayer insulation layer 170 and first and second contact electrodes 181 and 182, the upper wire structure 210 may be formed. The upper wire structure 210 may include the upper wires 211, the upper vias 212 and the upper insulation layer 213. An in an embodiment, the upper wire structure 210 may include the upper wires 211 of various layers formed through a plurality of repeated processes. First, after one layer of the upper insulation layer 213 is deposited on the upper surface of the interlayer insulation layer 170, this is patterned, and the upper wire 211 connected to the fourth via 182b may be formed. Thereafter, after one layer of the upper insulation layer 213 is deposited again, this may be patterned, and the upper via 212 may be formed on the upper wire 211 connected to the fourth via 182b. Thereafter, the upper wire 211 connected to the second end of the upper via 212 may be formed. The upper wires 211 and the upper vias 212 may include a metal (e.g., copper). The upper insulation layer 213 may be positioned on the upper surface of the interlayer insulation layer 170. The upper insulation layer 213 may cover the upper wires 211 and the upper vias 212. That is, the upper wires 211 and the upper vias 212 may be disposed within the upper insulation layer 213. The upper insulation layer 213 may include, for example, at least one of silicon oxide (SiO₂), silicon nitride (SiN), silicon nitride oxide (SiON), or low-k dielectric layers.

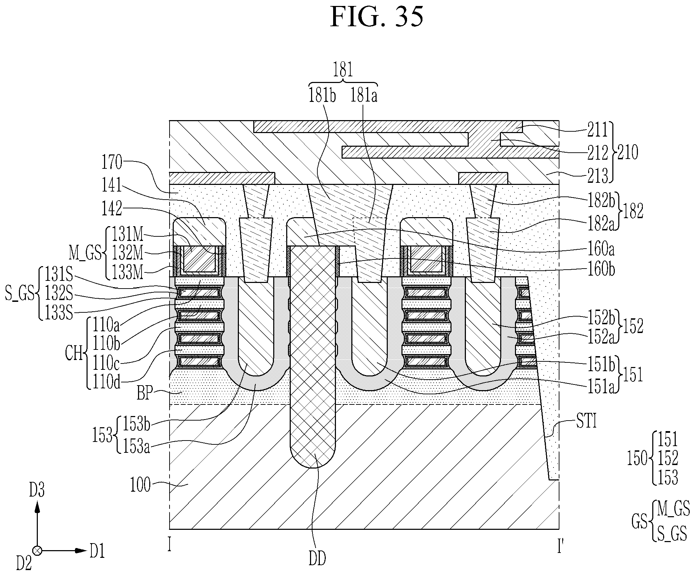

As shown in FIG. 35, the substrate 10 may be removed by performing an etching process. At this time, the process of thinning the substrate 10 by performing a chemical mechanical polishing (CMP) process with respect to the lower surface of the substrate 10 may be additionally performed. The etching process of removing the substrate 10 may be performed, for example, by a wet etching method. In this case, the substrate 10 may be etched by using an etchant having higher etch selectivity with respect to the substrate 10 compared to the dummy insulation pattern DD. However, but is not limited thereto, the substrate 10 may be removed by a dry etching process. As a partial region of the substrate 10 is removed, the dummy insulation pattern DD may be exposed. Subsequently, in the region where the substrate 10 is removed, the base insulation layer 100 covering the dummy insulation pattern DD may be formed. In an embodiment, the base insulation layer 100 may include a different insulating material from the interlayer insulation layer 170. In an embodiment, the base insulation layer 100 may include a different insulating material from the dummy insulation pattern DD. For example, the base insulation layer 100 may include silicon oxide (SiOx).

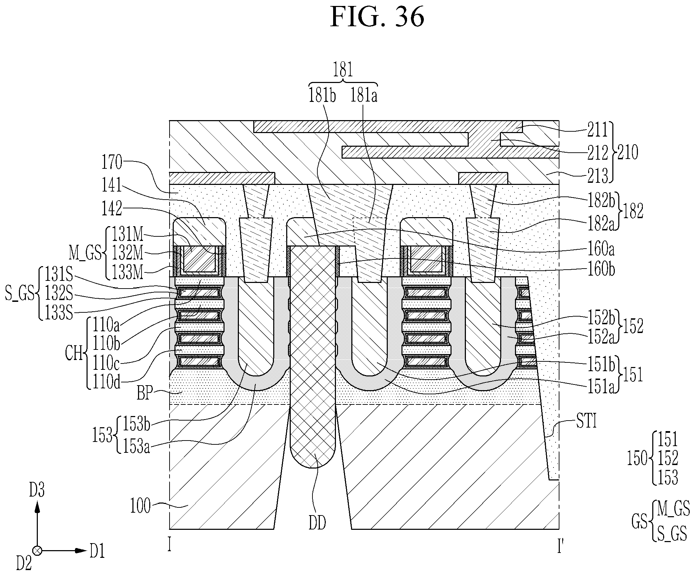

As shown in FIG. 36, by performing a photo and etching process, the base insulation layer 100 overlapping the dummy insulation pattern DD in the third direction D3, and at least a portion of the lower pattern BP surrounding the dummy insulation pattern DD may be etched. The base insulation layer 100 and the lower pattern BP may be sequentially removed. For example, a portion of the base insulation layer 100 overlapping the dummy insulation pattern DD in the third direction D3 may be first etched, and accordingly, a portion of the dummy insulation pattern DD may be exposed. At this time, a portion of the base insulation layer 100 may be etched by using an etchant having a higher etch selectivity with respect to the base insulation layer 100 compared to the dummy insulation pattern DD. Subsequently, a portion of the lower pattern BP may be etched. At this time, a portion of the lower pattern BP may be etched by using an etchant having a higher etch selectivity with respect to the lower pattern BP compared to the dummy insulation pattern DD. After the etching is completed, upper surfaces of the etched region may be positioned between the lower surfaces of the first and third source/drain patterns 151 and 153 and the upper surface of the base insulation layer 100.

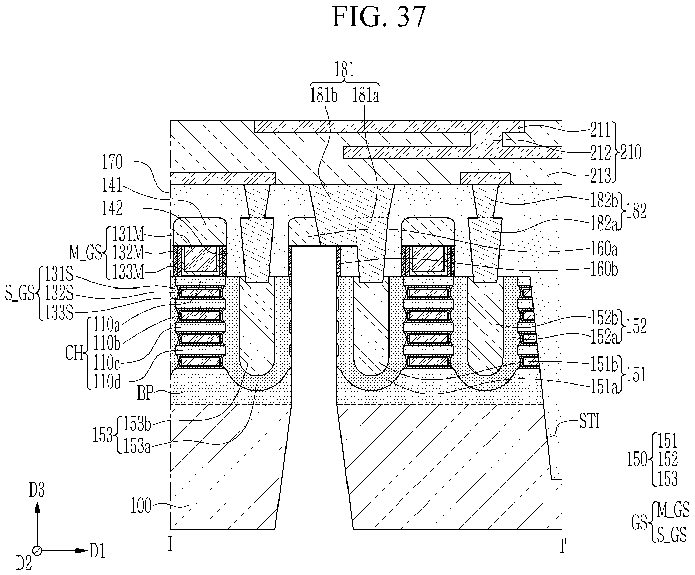

As shown in FIG. 37, the dummy insulation pattern DD exposed by the etching process may be removed. At this time, by using an etchant having a higher etch selectivity with respect to the dummy insulation pattern DD compared to the base insulation layer 100, the lower pattern BP and the source/drain pattern 150, the dummy insulation pattern DD may be etched.

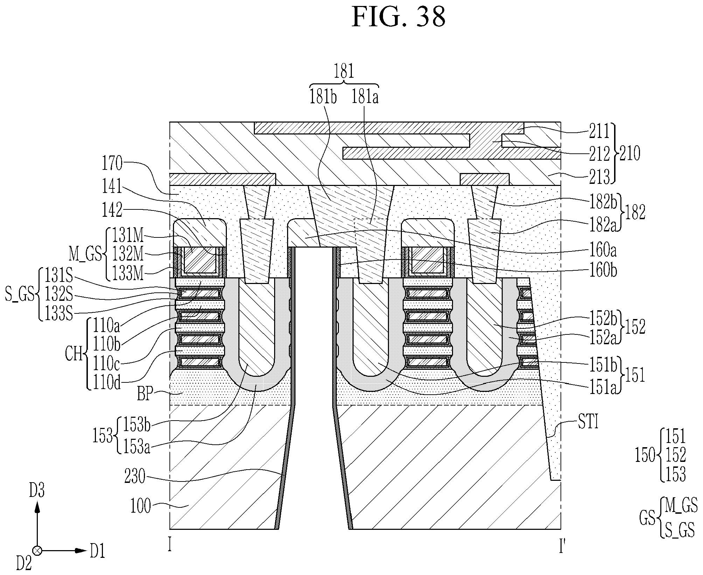

As shown in FIG. 38, along a side surface profile of the region where the dummy insulation pattern DD is removed and the region where the base insulation layer 100 and the lower pattern BP are removed, the barrier layer 230 may be formed. The barrier layer 230 may not be positioned on an upper surface (i.e., bottom surfaces of the second via 181b and the dummy capping layer 160a) of the region where the base insulation layer 100 and the lower pattern BP are removed. In order to form the barrier layer 230 only on side surfaces of the region where the dummy insulation pattern DD is removed and the region where the base insulation layer 100 and the lower pattern BP are removed, a plurality of photo processes and etching processes may be performed. For example, after forming the barrier layer 230 on entire side surfaces and upper surfaces of the region where the dummy insulation pattern DD is removed and the region where the base insulation layer 100 and the lower pattern BP are removed, by using an anisotropic etching process, only the barrier layer 230 formed on the upper surface may be separately removed.

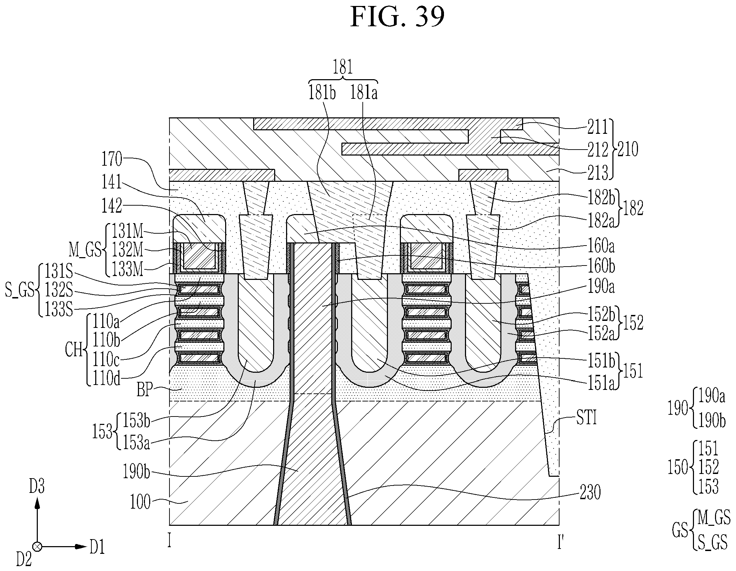

As shown in FIG. 39, the upper conductive pattern 190a and the lower conductive pattern 190b may be formed in the region where the dummy insulation pattern DD is removed and the region where the base insulation layer 100 and the lower pattern BP is removed. Referring to FIG. 39, it is illustrated as if the upper conductive pattern 190a and the lower conductive pattern 190b are separate configurations, but the upper conductive pattern 190a and the lower conductive pattern 190b may be integrally formed in the same process. The upper conductive pattern 190a and the lower conductive pattern 190b may include the same material. The upper conductive pattern 190a and the lower conductive pattern 190b may include a metal or metal alloy. For example, the upper conductive pattern 190a and the lower conductive pattern 190b may include at least one of titanium (Ti), tantalum (Ta), nickel (Ni), cobalt (Co) tungsten (W), molybdenum (Mo), ruthenium (Ru) and platinum (Pt).

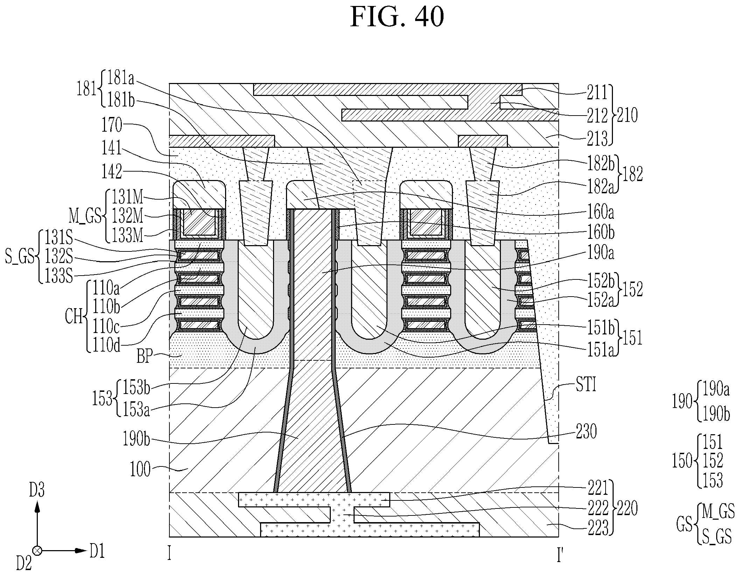

As shown in FIG. 40, the lower wire structure 220 may be formed on the lower surface of the base insulation layer 100. In an embodiment, the lower wire structure 220 may include the lower wires 221 of various layers formed through a plurality of repeated processes. First, after one layer of the lower insulation layer 223 is deposited on the bottom surface of the base insulation layer 100, it is patterned, and the lower wire 221 connected to the lower conductive pattern 190b may be formed. Thereafter, after one layer of the lower insulation layer 223 is deposited again, it is patterned, and the lower via 222 may be formed on the lower wire 221 connected to the lower conductive pattern 190b. Thereafter, the lower wire 221 connected to the second end of the lower via 222 may be formed. The lower wires 221 and the lower vias 222 may include a metal (e.g., copper). The lower insulation layer 223 may be positioned on the bottom surface of the base insulation layer 100. The lower insulation layer 223 may cover the lower wires 221 and the lower vias 222. That is, the lower wires 221 and the lower vias 222 may be disposed within the lower insulation layer 223. The lower insulation layer 223 may include, for example, at least one of silicon oxide (SiO₂), silicon nitride (SiN), silicon nitride oxide (SiON), or low-k dielectric layers.

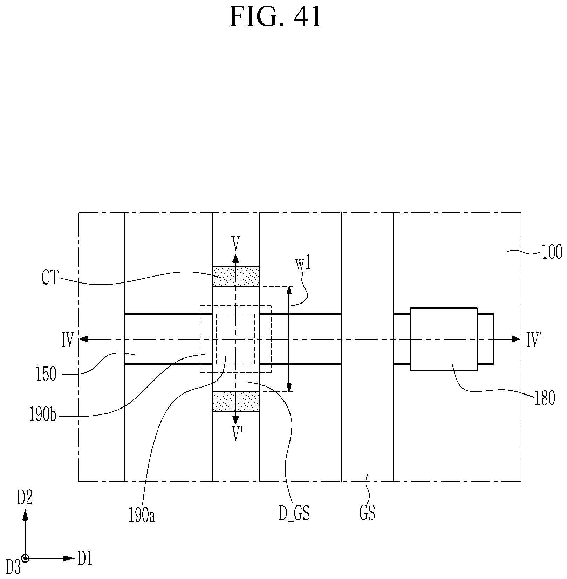

Hereinafter, referring to FIG. 41 to FIG. 43, a semiconductor device according to an embodiment will be described. The semiconductor device disclosed in FIG. 41 to FIG. 43 is substantially similar to the semiconductor device described with reference to FIG. 1 to FIG. 4, and hereinafter, the explanation is focused on differences between the semiconductor device disclosed in FIG. 41 to FIG. 43 and the semiconductor device described with reference to FIG. 1 to FIG. 4.

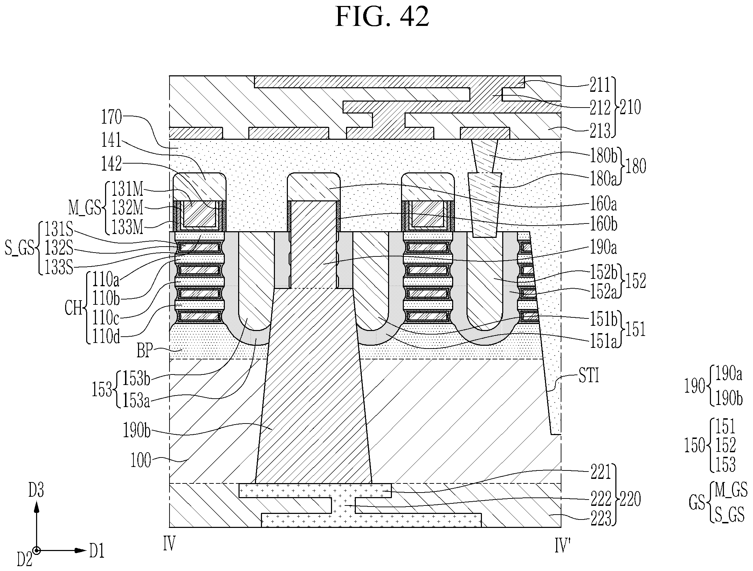

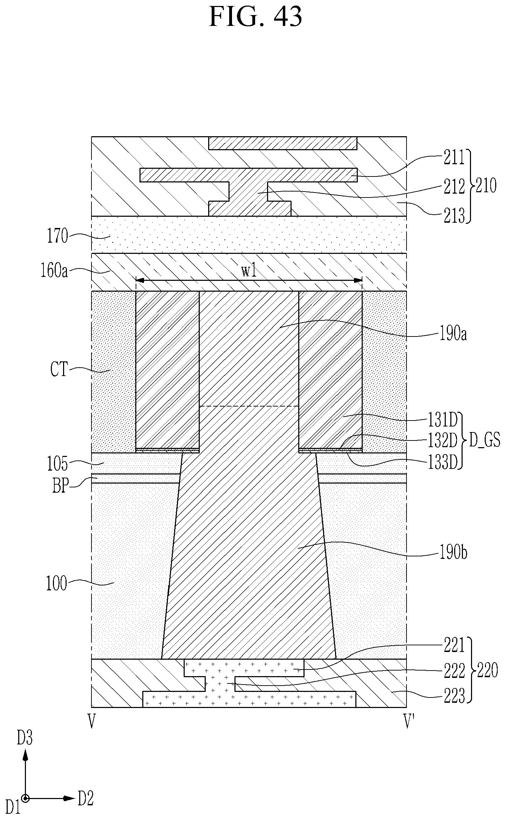

FIG. 41 is a top plan view showing a semiconductor device according to an embodiment. FIG. 42 is a cross-sectional view of a semiconductor device taken along line IV-IV' of FIG. 41. FIG. 43 is a cross-sectional view of a semiconductor device taken along line V-V' of FIG. 41.

Referring to FIG. 41 to FIG. 43, a semiconductor device according to an embodiment may include the base insulation layer 100, the channel layers CH positioned on the first surface of the base insulation layer 100, the source/drain patterns 150 positioned at the both sides of the channel layers CH, gate structures M_GS and S_GS surrounding the channel layer CH, the lower wire structure 220 positioned on the second surface of the base insulation layer 100, the through electrode 190 positioned to be spaced apart from the gate structure GS interposing the first source/drain pattern, and the dummy gate structure D_GS positioned on the field insulation layer 105.

The dummy gate structure D_GS may include a dummy gate electrode 131D positioned at the both sides of the through electrode 190, a dummy interface insulation layer 133D and a dummy gate insulation layer 132D positioned in a lower portion of the dummy gate electrode 131D.

A partial region of the dummy gate electrode 131D may be penetrated in the third direction D3 by the through electrode 190. That is, the dummy gate electrode 131D may positioned at both sides of the upper conductive pattern 190a and the lower conductive pattern 190b along the second direction D2. The dummy gate electrode 131D may be positioned on the field insulation layer 105. The dummy interface insulation layer 133D and the dummy gate insulation layer 132D may be positioned between the dummy gate electrode 131D and the field insulation layer 105. An upper surface of the dummy gate electrode 131D may contact a lower surface of a dummy capping layer 160c. The dummy gate electrode 131D may include a metal material. For example, the dummy gate electrode 131D may include the same material as the main gate electrode 131M described with reference to FIG. 2. For example, the dummy gate electrode 131D may include at least one of a metal, a metal alloy, a conductive metal nitride, a metal silicide, a doped semiconductor material, a conductive metal oxide, and a conductive metal nitride oxide. The dummy gate electrode 131D may be electrically separated from other gate electrodes positioned to be spaced apart in the first direction a gate separation pattern CT.

A dummy gate insulation layer 132D may extend along a bottom surface of the dummy gate electrode 131D. The dummy gate insulation layer 132D may include the same material as the main gate insulation layer 132M described with reference to FIG. 2. The dummy gate insulation layer 132D may include, for example, high dielectric constant material.

A dummy interface insulation layer 133D may be positioned between the dummy gate insulation layer 132D and the field insulation layer 105. The dummy interface insulation layer 133D may also be positioned between the dummy gate insulation layer 132D and the lower conductive pattern 190b. The dummy interface insulation layer 133D may extend along a lower surface of the dummy gate insulation layer 132D. The dummy interface insulation layer 133D may include the same material as the main interface insulation layer 133M described with reference to FIG. 2. For example, the dummy interface insulation layer 133D may include silicon oxide (SiO₂).

A semiconductor device according to an embodiment may further include the gate separation pattern CT. The gate separation pattern CT may electrically separate a plurality of gate electrodes (or dummy gate electrodes) arranged in the first direction D1. Referring to FIG. 41 and FIG. 43, the gate separation pattern CT may electrically separate a dummy gate electrode 131D from other gate electrodes (or other dummy gate electrodes) spaced apart in the first direction D1. The gate separation pattern CT may extend in the third direction D3. An upper surface of the gate separation pattern CT may contact the lower surface of the dummy capping layer 160a. A side surface of the gate separation pattern CT may contact the dummy gate electrode 131D. A lower surface of the gate separation pattern CT may be positioned at substantially the same height as a lower surface of the dummy gate electrode 131 D or the dummy gate structure D_GS. However, it is not limited thereto, and unlike what is shown in FIG. 43, the gate separation pattern CT may extend into the field insulation layer 105 or the lower pattern BP. In this case, the lower surface of the gate separation pattern CT may be positioned at a lower height than the lower surface of the dummy gate structure D_GS. In an embodiment, the gate separation pattern CT may include an insulating material. For example, the gate separation pattern CT may include silicon nitride (SiNx) and/or silicon oxide (SiOx). However, it is not limited thereto, and the gate separation pattern CT may include various insulating materials for electrically separating the dummy gate structure D_GS from other gate electrodes.

Referring to FIG. 41 to FIG. 43, a semiconductor device according to an embodiment may have electrode shapes of hole type. Specifically, in the semiconductor device described with reference to FIG. 1 to FIG. 4, whereas the lower conductive pattern 190b and the upper conductive pattern 190a has an electrode shape of a line type extend along the second direction D2 (refer to FIG. 1 and FIG. 4), in the case of the semiconductor device shown in FIG. 41 and FIG. 42, the lower conductive pattern 190b and the upper conductive pattern 190a may not extend in the second direction D2.

Referring to FIG. 41 to FIG. 43, widths of the lower conductive pattern 190b and the upper conductive pattern 190a in the second direction D2 may be smaller than a width w1 of the dummy gate structure D_GS in the second direction D2. The widths of the lower conductive pattern 190b and the upper conductive pattern 190a in the first direction D1 may be different. Referring to FIG. 41 and FIG. 43, the width of the lower conductive pattern 190b in the first direction D1 may be larger than the width of the upper conductive pattern 190a the in first direction. However, but is not limited thereto, the widths of the lower conductive pattern 190b and the upper conductive pattern 190a in the first direction D1 may be the same.

While the embodiment of the present disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

## Claims

1. A semiconductor device, comprising:
a base insulation layer (100) including a first surface and a second surface opposing each other;
a channel layer (CH) on the first surface of the base insulation layer (100);
a first source/drain pattern (151) and a second source/drain pattern (152) spaced apart from each other in a first direction (D1) on the first surface of the base insulation layer (100) with the channel layer (CH) therebetween, the first direction (D1) being parallel to the first surface of the base insulation layer (100);
a gate structure (GS) extending in a second direction (D2) on the first surface of the base insulation layer (100), the second direction (D2) crossing the first direction (D1), and the gate structure (GS) surrounding the channel layer (CH);
a lower wire structure (220) on the second surface of the base insulation layer (100); and
a through electrode (190) spaced apart from the gate structure (GS) with the first source/drain pattern (151) between the through electrode (190) and the gate structure (GS), the through electrode (190) penetrating the base insulation layer (100) and electrically connecting the first source/drain pattern (151) to the lower wire structure (220).

2. The semiconductor device of claim 1, wherein an upper surface of the through electrode (190) is a same level as an upper surface of the gate structure (GS).

3. The semiconductor device of claim 1, wherein
the through electrode (190) comprises an upper conductive pattern (190a) and a lower conductive pattern (190b) below the upper conductive pattern (190a),
the upper conductive pattern (190a) is positioned at a first side of the first source/drain pattern (151),
a width of the lower conductive pattern (190b) is wider than a width of the upper conductive pattern (190a), and
the lower conductive pattern (190b) is connected to the lower wire structure (220).

4. The semiconductor device of claim 3, wherein
the width of the upper conductive pattern (190a) in the first direction (D1) is equal to a width of the gate structure (GS) in the first direction (D1).

5. The semiconductor device of claim 3 or 4, further comprising:
a gate spacer (142) on a side surface of the gate structure (GS);
a capping layer (141) on an upper surface of the gate structure (GS);
a dummy gate spacer (160b) on a side surface of the upper conductive pattern (190a); and
a dummy capping layer (160a) on an upper surface of the upper conductive pattern (190a),
wherein the dummy gate spacer (160b) and the gate spacer (142) have same materials as each other and are portions of a same layer,
wherein the dummy capping layer (160a) and the capping layer (141) have same materials as each other and are parts of one layer.

6. The semiconductor device of any one of claims 1 to 5, further comprising:
a third source/drain pattern (153) on the first surface of the base insulation layer (100) and spaced apart from the first source/drain pattern (151) in the first direction (D1),
wherein the through electrode (190) is between the first source/drain pattern (151) and the third source/drain pattern (153) and electrically connected to the first source/drain pattern (151) and the third source/drain pattern (153).

7. The semiconductor device of claim 6, wherein the through electrode (190) extends in the second direction (D2).

8. The semiconductor device of claim 6 or 7, further comprising:
a dummy gate electrode (131D) positioned at both sides of the through electrode (190) along the second direction (D2), wherein
an upper surface of the dummy gate electrode (131D) is coplanar with an upper surface of the gate structure (GS) and an upper surface of the through electrode (190).

9. The semiconductor device of any one of claims 1 to 8, further comprising:
a first contact electrode (181) electrically connecting the first source/drain pattern (151) and the through electrode (190) to each other.

10. The semiconductor device of claim 9, further comprising:
an interlayer insulation layer (170) on the gate structure (GS) and the through electrode (190);
an upper wire structure (210) on the interlayer insulation layer (170); and
a second contact electrode (182) electrically connecting the second source/drain pattern (152) and the upper wire structure (210) to each other, wherein
the first contact electrode (181) and the second contact electrode (182) have same materials as each other and are parts in a same contact electrode layer.

11. A method of manufacturing a semiconductor device, the method comprising:
forming a channel layer (CH), a first source/drain pattern (151), and a second source/drain pattern (152) on a first surface of a substrate (10) with the channel layer (CH) between the first source/drain pattern (151) and the second source/drain pattern (152) in a first direction (D1), the first direction (D1) being parallel to the first surface of the substrate (10);
forming a gate structure (GS) extending in a second direction (D2) on the first surface of the substrate (10), the gate structure (GS) surrounding the channel layer (CH) in the second direction (D2), the second direction (D2) crossing the first direction (D1);
forming a base insulation layer (100), the forming the base insulation layer (100) including removing a portion or all of the substrate (10) and forming the base insulation layer (100) in a region in which the portion or all of the substrate (10) is removed;
forming a through electrode (190) spaced apart from the gate structure (GS) with the first source/drain pattern (151) between the through electrode (190) and the gate structure (GS), the through electrode (190) penetrating the base insulation layer (100) and being connected to the first source/drain pattern (151); and
forming a lower wire structure (220) on a lower surface of the base insulation layer (100), the lower wire structure (220) being connected to the through electrode (190).

12. The method of claim 11, wherein an upper surface of the through electrode (190) is at a same level as an upper surface of the gate structure (GS).

13. The method of claim 11 or 12, wherein
the forming the through electrode (190) comprises forming an upper conductive pattern (190a) and a lower conductive pattern (190b) below the upper conductive pattern (190a),
the upper conductive pattern (190a) is formed at a first side of the first source/drain pattern (151),
a width of the lower conductive pattern (190b) is wider than a width of the upper conductive pattern (190a), and
the lower conductive pattern (190b) is connected to the lower wire structure (220).

14. The method of claim 13, wherein the width of the upper conductive pattern along the first direction (D1) is equal to a width of the gate structure (GS) along the first direction (D1).

15. The method of claim 13 or 14, further comprising:
forming a gate spacer (142) on the substrate (10);
forming a capping layer (141) covering an upper surface of the gate structure (GS); and
forming a dummy capping layer (160a) on an upper surface of the upper conductive pattern (190a);
forming a dummy gate spacer (160b) on the substrate (10),
wherein the gate spacer covers a side surface of the gate structure (GS),
wherein the dummy gate spacer covers a side surface of the upper conductive pattern,
wherein the dummy gate spacer (160b) and the gate spacer '(142) have same materials as each other and are portions of a same layer, and
wherein the dummy capping layer (160a) and the capping layer (141) have same materials as each other and are parts of one layer.
